# EUROPEAN PATENT APPLICATION

(11) **EP 1 650 808 A1**
(43) Date of publication of application: **26.04.2006**
(21) Application number: 03780839.1
(22) Date of filing: 17.12.2003
(51) Int. Cl.: H01L 29/66, H01L 29/06, H01L 29/786

(54) **ELECTRONIC ELEMENT, INTEGRATED CIRCUIT AND PROCESS FOR FABRICATING THE SAME**

(30) Priority: 25.07.2003 JP 2003280374
(71) Applicant: FUJI XEROX CO., LTD, Minato-ku Tokyo 107-0052 (JP)
(72) Inventor: HIRAKATA, Masaki, c/o Fuji Xerox Co., Ltd., Ashigarakami-gun, Kanagawa 259-0157 (JP); ISOZAKI, Takashi, c/o Fuji Xerox Co., Ltd., Ashigarakami-gun, Kanagawa 259-0157 (JP); KISHI, Kentaro, c/o Fuji Xerox Co., Ltd., Ashigarakami-gun, Kanagawa 259-0157 (JP); SHIGEMATSU, Taishi, c/o Fuji Xerox Co., Ltd., Ashigarakami-gun, Kanagawa 259-0157 (JP); WATANABE, Miho, c/o Fuji Xerox Co., Ltd., Ashigarakami-gun, Kanagawa 259-0157 (JP); MANABE, Chikara, c/o Fuji Xerox Co., Ltd., Ashigarakami-gun, Kanagawa 259-0157 (JP); ANAZAWA, Kazunori, c/o Fuji Xerox Co., Ltd., Ashigarakami-gun, Kanagawa 259-0157 (JP); WATANABE, Hiroyuki, c/o Fuji Xerox Co., Ltd., Ashigarakami-gun, Kanagawa 259-0157 (JP); OKADA, Shinsuke, c/o Fuji Xerox Co., Ltd., Ashigarakami-gun, Kanagawa 259-0157 (JP); OOMA, Shigeki, c/o Fuji Xerox Co., Ltd., Ashigarakami-gun, Kanagawa 259-0157 (JP)
(74) Representative: Forstmeyer, Dietmar
(86) International application number: PCT/JP2003/016172
(87) International publication number: WO 2005/010995

(57) **Abstract**

The present invention provides an electronic device including a transporting layer which involves a low environmental load and which is excellent in semiconductor characteristics by means of a configuration having, on the surface of a base body, at least a transporting layer constituted by a carbon nanotube structure layer having a network structure in which a plurality of carbon nanotubes mutually cross-link. Also, provided is a method of manufacturing the same.

## Description

### TECHNICAL FIELD

The present invention relates to an electronic device using a carbon nanotube structure as a transporting layer, an integrated circuit using the electronic device, and a method of manufacturing the same.

### Background Art

Carbon nanotubes (CNTs), with their unique shapes and characteristics, are being considered for various applications. A carbon nanotube has a tubular shape of one-dimensional nature which is obtained by rolling one or more graphene sheets composed of six-membered rings of carbon atoms into a tube. A carbon nanotube which is formed from one graphene sheet is called a single-wall nanotube (SWNT), while a carbon nanotube which is formed frommultiple graphene sheets is called a multi-wall nanotube (MWNT). SWNTs are about 1 nm in diameter, while multi-wall carbon nanotubes measure several tens nm in diameter, and both are far thinner than their predecessors, which are called carbon fibers.

One of the characteristics of carbon nanotubes resides in that the aspect ratio of length to diameter is very large since the length of carbon nanotubes is on the order of micrometers. Carbon nanotubes are unique in their extremely rare nature of being both metallic and semiconductive because six-membered rings of carbon atoms in carbon nanotubes are arranged into a spiral. In addition, the electric conductivity of carbon nanotubes is very high and allows a current flow at a current density of 100 MA/cm² or more.

Carbon nanotubes excel not only in electrical characteristics but also in mechanical characteristics. That is, the carbon nanotubes are distinctively tough, as attested by their Young's moduli exceeding 1 TPa, which belies their extreme lightness resulting from being formed solely of carbon atoms. In addition, the carbon nanotubes have high elasticity and resiliency resulting from their cage structure. Having such various and excellent characteristics, carbon nanotubes are very appealing as industrial materials.

Applied researches that exploit the excellent characteristics of carbon nanotubes have been heretofore made extensively. To give a few examples, a carbon nanotube is added as a resin reinforcer or as a conductive composite material, while another research utilizes a carbon nanotube as a probe of a scanning probe microscope. Carbon nanotubes have also been utilized as minute electron sources, field emission electronic devices, and flat displays. An application that is being developed is to use as a hydrogen storage a carbon nanotube.

In association with a recent increase in speed of information processing or communication, an electrical signal with a frequency equal to or higher than a frequency that can be processed by means of a transistor using silicon or gallium arsenide currently used must be controlled or amplified. In addition, a substance applying a large load to the environment may be used for an electronic device itself produced by using silicon, gallium arsenide, or the like, or may be used in a production step of the device. In view of the above, a carbon nanotube which is composed of carbon applying a small load to the environment and is considered to operate at a frequency higher than those of silicon and gallium arsenide has been attracting attention, and an electronic device such as a transistor has been prototyped by using the carbon nanotube. However, a handling technique on the order of nanometer is necessary to put an electronic device using a carbon nanotube such as that described above into practical use.

For example, JP-A 2003-17508 discloses a field effect transistor constituted by arranging a plurality of carbon nanotubes in parallel between source and drain electrodes. In the method of arranging those carbon nanotubes, a self-organizing molecular membrane is used and the chargeability of the molecular membrane is made to differ from site to site, whereby a carbon nanotube having property of being negatively charged can be arranged at an arbitrary position. However, a carbon nanotube is a very thin fibrous material . Even if part of the carbon nanotube adsorbs to an area showing positive chargeability, the carbon nanotube is not necessarily arranged to connect the source and the drain. Therefore, the carbon nanotube may be connected to only one of them or may be arranged between the electrodes without connecting them, which is too uncertain. Alternatively, a photo tweezer method or an orientation method by means of an electric field are disclosed, but these methods are not different from the above method in that the connection occurs only by chance, and hence are insufficient as techniques for integration.

Meanwhile, an attempt has been made, which includes: dispersing a carbon nanotube into a liquid; applying and depositing the dispersion onto a substrate; and using the applied film as a transporting layer (channel). For example, "Random networks of carbon nanotubes as an electronic material", written by E. S. Snow, J. P. Novak, P. M. Campbell, and D. Park, APPLIED PHYSICS LETTERS (U.S.A), 2003, Vol. 82, No. 13, p. 2145 to p. 2147 reports that a liquid into which single-wall carbon nanotubes are dispersed at a high density is applied, whereby many connections are made to connect the carbon nanotubes, and thus the applied liquid can be used for a thin film transistor. In a mere dispersion film, an electrical pulse may occur somewhere if a channel has a large area, but the probability of the occurrence reduces as the channel is thinned, so high density is hardly obtained. Furthermore, for performing thinning and integration, an excessive nanotube must be cut and removed because a tip of a long carbon nanotube lying off the area may establish a short circuit with other device or wiring. However, it is extremely difficult to pattern a deposit in a contact state, and carbon nanotubes scatter during an etching operation, so patterning is impossible in fact. In addition, the deposit is merely in contact, so there arises a drawback in that the resultant device is unstable and the current fluctuates in association with vibration or application of a voltage.

An approach to solving the drawback of the applied film due to contact of a carbon nanotube is, for example, a method involving:
dispersing a carbon nanotube in a resin; and solidifying or applying the dispersion. For example, JP-A 2003-96313 discloses a method of manufacturing a thin film transistor by using a composite obtained by dispersing carbon nanotubes into a polymer. However, contact between carbon nanotubes hardly occurs owing to the presence of the resin, thereby leading to a problem in terms of electrical contact. In addition, the density of carbon nanotubes reduces owing to the presence of the resin, so the number of electrical paths reduces, thereby making it difficult to use the device as an electronic device. If a mixing amount of carbon nanotubes is increased to solve this, an amount of binders reduces, with the result that the strength of the dispersion film itself reduces and the same problem as that of the above deposit film occurs.

Therefore, an object of the present invention is to solve the problems in the prior art. More specifically, an object of the present invention is to provide: an electronic device capable of stably obtaining characteristics of a carbon nanotube; and a manufacturing method with which a uniform electronic device can be stably obtained.

### Disclosure of the Invention

The above object is achieved by the present invention described below.

That is, according to one aspect of the present invention, there is provided an electronic device, characterized by including:
three or more electrodes; and a transporting layer constituted by a carbon nanotube structure formed into a network structure by a plurality of carbon nanotubes and cross-linked sites each constituted by chemical bonding of the different carbon nanotubes,
in which a carrier is transported in accordance with a voltage applied to the electrodes.

In the electronic device of the present invention, a carbon nanotube structure formed into a network structure by a plurality of carbon nanotubes and cross-linked sites in each of which the different carbon nanotubes cross-link through chemical bonding is used as a transporting layer. Therefore, as compared to the case
where a mere carbon nanotube dispersion film is used as the transporting layer, a phenomenon does not occur in which an electrical path is lost or fluctuates owing to the instability of the contact state and arrangement state of carbon nanotubes. As a result, the device can be allowed to stably operate as an electronic device. The term "electrical path" refers to a conduction path of a carrier (hole, electron) to be transported in the transporting layer. In addition, in the electrical path, a carrier is not necessarily conducted in a cross-linked site. The transmission of a carrier may be performed by virtue of a tunnel effect or the like when a cross-linked site is sufficiently short. A clear theory has not been established yet for the principle of carrier transmission not only in a carbon nanotube structure with a network structure but also a carbon nanotube dispersion. Therefore, future research may enable the principle to be explained with improved validity. It is apparent, however, that those facts do not negate the effectiveness of the electronic device obtained by the structure of the present invention.

Next, the electronic device of the present invention includes three or more electrodes. In particular, it is preferable to constitute the electrodes as the source, drain, and gate electrodes of a field effect transistor. More than three electrodes may be arranged. For example, a plurality of gate electrodes may be arranged. In addition, a gate electrode may be arranged above or below the transporting layer. The gate electrode is not necessarily formed into a planar shape, and may be formed into a three-dimensional shape to cover the transporting layer to thereby enhance the action of a gate voltage.

A field effect transistor having a MOS-FET (metal oxide semiconductor field effect transistor) structure is effective in constituting a highly integrated device because operating power can be reduced and switching characteristics become good.

In addition, a field effect transistor having a MES-FET (metal semiconductor field effect transistor) structure is effective in performing a switching operation at a high speed. In particular, in the case where a carbon nanotube structure is used as the transporting layer, a switching speed can be increased because a carbon nanotube has a high carrier transporting speed.

The carbon nanotube structure has a network structure in which cross-linked sites are connected with a carbon nanotube. The carbon nanotube is preferably a single-wall carbon nanotube because intrinsic semiconductor characteristics can be easily exploited.

In the case where the carbon nanotubes are mainly multi-wall carbon nanotubes, a graphene sheet structure on a surface layer is partly destroyed when a cross-linked site binds to a carbon nanotube. However, such a case is preferable in that another graphene sheet layer is formed at the center and an electrical path is easily formed without the rupture of the carbon nanotube structure. Multi-wall carbon nanotubes are not limited to merely completely concentric and cylindrical ones, and include tubes whose vertical cross section taken along their center axis has a multilayer structure such as so-called cup-stacked carbon nanotubes.

The term "mainly" refers to which one of a component ratio of single-wall carbon nanotubes and a component ratio of multi-wall carbon nanotubes is larger than the other. In general, in most cases, one of the component ratio of single-wall carbon nanotubes and the component ratio of multi-wall carbon nanotubes is overwhelmingly large as compared to the other in accordance with a manufacturing method of a carbon nanotube. Since such carbon nanotubes are supplied to the market while single-wall and multi-wall carbon nanotubes are distinguished from each other, one of the single-wall and multi-wall carbon nanotubes can be selected and used in producing the electronic device of the present invention. In addition, the single-wall and multi-wall carbon nanotubes may be intentionally mixed and used.

By the way, a multi-wall carbon nanotube, unlike a single-wall carbon nanotube, is said to have electrical characteristics similar to those of a metal. It has become clear that the carbon nanotube structure of the present invention in which a cross-linked site is formed operates also as a transporting layer. Although the reason for this is unclear, the result will be shown in Examples below. The cross-linked site presumably acts as a structure like a Schottky barrier, but the validity of this presumption is unclear. However, it has been found that a transporting layer is formed by using a multi-wall carbon nanotube which can be produced with high purity and in a large amount as compared to a single-wall carbon nanotube and which can be easily handled. As a result, it becomes extremely easy to industrially produce applied active devices of carbon nanotubes in large amounts.

A chemical bond constituting a cross-linked site is preferably a chemical structure selected from the group consisting of -COO(CH₂)₂OCO-, -COOCH₂CHOHCH₂OCO-, -COOCH₂CH(OCO-) CH₂OH-, -COOCH₂CH (OCO-) CH₂OCO-, and -COO-C₆H₄-COO-. Each of those bonds is an extremely short structure as compared to the length of a carbon nanotube. Therefore, a distance between carbon nanotubes at a cross-linked site can be made extremely short. As a result, the density of carbon nanotubes in a carbon nanotube structure can be increased, thereby facilitating the formation of an electrical path. As a result, even if the size of the transporting layer becomes small, the device can be allowed to stably operate as an electronic device. Alternatively, the amount of a current that can be passed through the transporting layer can be increased. In particular, in the case where -COO-C₆H₄-COO- is adopted as the structure of the cross-linked site, electrical characteristics are stable, which is preferable in that deterioration with time is suppressed.

The chemical bond constituting the cross-linked site is also preferably one selected from the group consisting of -COOCO-, -O-, -NHCO-, -COO-, -NCH-, -NH-, -S-, -O-, -NHCOO-, and -S-S- because of the same reason as that described in the above paragraph.

The carbon nanotube structure is preferably obtained by using a solution containing a plurality of carbon nanotubes to which functional groups are bonded, to thereby form a cross-linked site through chemical bonding of the functional groups connected to the carbon nanotubes.

By using carbon nanotubes to which functional groups are bonded in advance, the amount of cross-linking is controlled and the density of nanotubes and the amount of cross-linked sites formed in the carbon nanotube structure can be uniformized. As a result, even in case of integration, large variations in characteristics of an electronic device due to the position of the carbon nanotube structure can be reduced. If a chemical bond to directly cross-link separated nanotubes is allowed to occur for forming a network-like carbon nanotube structure, the carbon nanotubes hardly cross-link or the graphene sheet structure on the nanotube surface is entirely destroyed because the stability of the surface of a carbon nanotube is extremely high. Therefore, it is hard to obtain a desired network structure.

In a carbon nanotube structure, a cross-linked site is more preferably formed by curing a solution containing carbon nanotubes having functional groups and a cross-linking agent that prompts a cross-linking reaction with the functional groups, to prompt a cross-linking reaction between each of the functional groups bonded to different carbon nanotubes and the cross-linking agent. Combination of a functional group causing cross-linking and a cross-linking agent can be selected, so a chemical bond constituting a cross-linked site can be of a desired structure, and an electronic device having desired characteristics can be obtained.

Furthermore, the cross-linking agent is preferably a non-self-polymerizable cross-linking agent.

If the cross-linking agent has its property of polymerizing with other cross-linking agents (self-polymerizability), the connecting group may contain a polymer in which two or more cross-linking agents are connected, thereby reducing an actual density of the carbon nanotubes in the carbon nanotube structure. Therefore, the transporting layer may be unable to exert sufficient semiconductivity.

On the other hand, when the cross-linking agent is a non-self-polymerizable cross-linking agent, a gap between carbon nanotubes can be controlled to the size of a product as a result of the cross-linking reaction between a functional group and a cross-linking agent used. Therefore, a desired network structure of carbon nanotubes can be obtained with high duplicability. Further, reducing the size of the residue after the reaction of the cross-linking agent can extremely narrow a gap between carbon nanotubes electrically and physically. In addition, carbon nanotubes in the structure can be densely structured. Therefore, a fine electronic device can be formed, or the amount of a current that can be passed through the transporting layer can be increased.

In the present invention, the term "self-polymerizable" refers to property with which the cross-linking agents may prompt a polymerization reaction with each other in the presence of other components such as water or in the absence of other components. On the other hand, the term "not self-polymerizable" means that the cross-linking agent has no such property.

Examples of the functional groups include -OH, -COOH, -COOR (where R represents a substituted or unsubstituted hydrocarbon group), -COX (where X represents a halogen atom), -NH₂, and -NCO. A selection of at least one functional group from the group consisting of the above functional groups is preferable, and in such a case, a cross-linking agent, which may prompt a cross-linking reaction with the selected functional group, is selected as the cross-linking agent.

Further, examples of the preferable cross-linking agent include a polyol, a polyamine, a polycarboxylic acid, a polycarboxylate, a polycarboxylic acid halide, a polycarbodiimide, a polyisocyanate, and hydroquinone. A selection of at least one cross-linking agent from the group consisting of the above cross-linking agents is preferable, and in such a case, a functional group, which may prompt a cross-linking reaction with the selected cross-linking agent, is selected as the functional group.

At least one functional group and at least one cross-linking agent are preferably selected respectively from the group consisting of the functional groups exemplified as the preferable functional groups and the group consisting of the cross-linking agents exemplified as the preferable cross-linking agents, so combination of the functional group and the cross-linking agent may prompt a cross-linking reaction with each other.

Examples of the particularly preferable functional group include -COOR (where R represents a substituted or unsubstituted hydrocarbon group). Introduction of a carboxyl group into carbon nanotubes is relatively easy, and the resultant substance (carbon nanotube carboxylic acid) has high reactivity. Therefore, after the formation of the substance, it is relatively easy to esterify the substance to convert its functional group into -COOR (where R represents a substituted or unsubstituted hydrocarbon group). The functional group easily prompts a cross-linking reaction and is suitable for formation of an applied film.

A polyol can be exemplified as the cross-linking agent corresponding to the functional group. A polyol is cured by a reaction with -COOR (where R represents a substituted or unsubstituted hydrocarbon group), and forms a robust cross-linked substance with ease. Among polyols, each of glycerin and ethylene glycol reacts with the above functional groups well. Moreover, each of glycerin and ethylene glycol itself is highly biodegradable, and provides a low environmental load.

A second preferable structure of the cross-linked site is formed by chemical bonding of the functional groups. In this case, functional groups connected in advance to carbon nanotubes are bonded. Therefore, the resultant electronic device using a carbon nanotube structure has desired characteristics. In addition, the density of the carbon nanotube structure can be increased as compared to the case where a cross-linking agent is interposed between functional groups.

A reaction for chemically bonding functional groups is preferably one selected from dehydration condensation, a substitution reaction, an addition reaction, and an oxidation reaction.

In the electronic device of the present invention, in the case where the carbon nanotube structure is patterned into a shape corresponding to a formation area of the transporting layer, carbon nanotubes are chemically bonded at a cross-linked site. Therefore, no electrical path in the pattern is lost, and a stable operation can be achieved. Furthermore, the carbon nanotube structure formed into a network structure by cross-linked sites in each of which carbon nanotubes cross-link through chemical bonding, unlike a carbon nanotube dispersion film due to accidental contact, entirely forms a uniform structure. Therefore, variations in characteristics of the transporting layer due to the position of the carbon nanotube structure before the patterning are small, and variations in characteristics of the electronic device after the patterning are reduced.

In addition, when an electronic device having, as a transporting layer, a carbon nanotube structure formed into a network structure by cross-linked sites in each of which carbon nanotubes cross-link through chemical bonding is formed on a flexible substrate, variations in characteristics caused by a change of an electrical path involving deformation such as bending of a substrate, which cannot be avoided in a conventional electronic device having a transporting layer in which carbon nanotubes mutually contact, are reduced.

In addition, in the electronic device of the present invention, an electrical path in the structure is homogeneously formed. Therefore, even in the case where the device is formed as an integrated circuit on a substrate, an integrated circuit in which variations in characteristics of each device are small can be obtained.

According to another aspect of the present invention, there is provided a method of manufacturing an electronic device that includes, on a base body, three or more electrodes and a transporting layer in which a carrier is transported in accordance with a voltage applied to the electrodes, the method being characterized by including: a supplying step of supplying the base body with a solution containing a plurality of carbon nanotubes to which functional groups are bonded; and a cross-linking step of chemically bonding the functional groups together to construct a network structure in which the carbon nanotubes mutually cross-link, thereby forming a carbon nanotube structure used as the transporting layer.

In the present invention, in the supplying step of supplying a base body surface with a solution containing carbon nanotubes having functional groups (hereinafter, the solution may be referred to as a "cross-linking application solution"), the entire surface or part of the surface of the base body, or an inside or the like of a desired mold is supplied with the cross-linking application solution. Then, in the subsequent cross-linking step, the functional groups are chemically bonded together to construct a network structure in which the carbon nanotubes mutually cross-link, thereby forming a carbon nanotube structure. Then, the carbon nanotube structure layer is used as the transporting layer. Through those two steps, the structure itself of the carbon nanotube structure layer is stabilized on the base body surface.

If the supplying step includes an applying step of applying the solution onto the base body, and the carbon nanotube structure is of a film shape, a layered carbon nanotube structure having a network structure can be obtained. As described later, the structure can be patterned readily into a desired shape. This case is preferable in forming a thin-layer device.

The carbon nanotubes to be used in the method of the present invention are preferably single-wall carbon nanotubes because intrinsic semiconductor characteristics can be easily exploited.

In the case where the carbon nanotubes are mainly multi-wall carbon nanotubes, as described in the electronic device, it has been found that a transporting layer is formed by using a multi-wall carbon nanotube which can be produced with high purity and in a large amount as compared to a single-wall carbon nanotube and which can be easily handled. This finding is extremely useful in industrially producing applied active devices of carbon nanotubes in large amounts.

The term "mainly" refers to which one of a component ratio of single-wall carbon nanotubes and a component ratio of multi-wall carbon nanotubes used for producing a carbon nanotube structure is larger than the other. In general, in most cases, one of the component ratio of single-wall carbon nanotubes and the component ratio of multi-wall carbon nanotubes is overwhelmingly large as compared to the other in accordance with a manufacturing method of a carbon nanotube. Therefore, it is only necessary to select one of the single-wall and multi-wall carbon nanotubes. However, the single-wall and multi-wall carbon nanotubes also may be intentionally mixed and used.

In addition, a top-down integrated circuit can be easily produced by combination with the formation of a transporting layer through patterning of a carbon nanotube structure to be described later.

A preferable first method of forming a cross-linked site in the method of manufacturing an electronic device of the present invention is a method involving incorporating a cross-linking agent for cross-linking the functional groups in the solution. Since the combination of a functional group and a cross-linking agent which cross-links the functional group is determined, unlike a carbon nanotube dispersion film, it becomes possible to ensure that the formation of cross-linking occurs.

In addition, a non-self-polymerizable cross-linking agent is preferably used as the cross-linking agent. When a self-polymerizable cross-linking agent is used as the cross-linking agent, and cross-linking agents prompt a polymerization reaction with each other during or prior to the cross-linking reaction in the cross-linking step, bonding between the cross-linking agents is enlarged and lengthened. As a result, a gap itself between carbon nanotubes to be bonded to the agents may be inevitably large. At this time, since it is in fact difficult to control the degree of the reaction due to the self-polymerizability between the cross-linking agents, a cross-linking structure between carbon nanotubes in the structure may vary in accordance with a variation in a polymerization state between the cross-linking agents.

However, when a non-self-polymerizable cross-linking agent is used, cross-linking agents do not mutually polymerize at least during and prior to the cross-linking step. In addition, in the cross-linked site between the carbon nanotubes, only a residue by one cross-linking reaction of the cross-linking agent is interposed as a connecting group between residues of the functional groups remaining after the cross-linking reaction. As a result, the characteristics of the resultant carbon nanotube structure layer are entirely uniformized. Even when the layer is patterned in a patterning step, variations in characteristics of the carbon nanotube structure layer after the patterning can be significantly reduced.

The functional groups are preferably at least one group selected from the group consisting of -OH, -COOH, -COOR (where R represents a substituted or unsubstituted hydrocarbon group), -COX (where X represents a halogen atom), -NH₂, and -NCO from the viewpoint of the ease with which carbon nanotubes bind to functional groups.

Further, the cross-linking agents are preferably at least one cross-linking agent selected from the group consisting of a polyol, a polyamine, a polycarboxylic acid, a polycarboxylate, a polycarboxylic acid halide, a polycarbodiimide, a polyisocyanate, and hydroquinone because the size of a cross-linked site can be reduced to an appropriate one. If the size of a cross-linking agent is excessively large, carbon nanotubes are substantially isolated from each other, and the effect of connection at the cross-linked site is hardly obtained.

The functional groups are particularly preferably -COOR (where R represents a substituted or unsubstituted hydrocarbon group) from the viewpoint of the ease with which carbon nanotubes bind to functional groups. At this time, the cross-linking agents are preferably polyols, more preferably glycerin and/or ethylene glycol from the viewpoints of the ease with which a non-self-polymerizable cross-linking agent and -COOR prompt a cross-linking reaction as described above, the ease with which an applied film is formed, high biodegradability, and a low environmental load.

In addition, when the cross-linking agents do not mutually cross-link, or differ from each other in reactivity with respect to the functional groups bonded to the carbon nanotubes, a gap between carbon nanotubes can be controlled even if multiple kinds of non-self-polymerizable cross-linking agents are mixed to cross-link carbon nanotubes. As a result, a similar reducing effect on variations can be obtained. On the other hand, in the case where cross-linking is performed by using cross-linking agents different in a stepwise manner, if cross-linking is performed by using a non-self-polymerizable cross-linking agent at an initial cross-linking stage, the skeleton of a network structure of the carbon nanotube is complete in a state where a distance between carbon nanotubes is controlled. Therefore, a self-polymerizable cross-linking agent or a cross-linking agent that cross-links the initial cross-linking agent (or a residue thereof) may be used in the subsequent cross-linking step.

In the method of manufacturing an electronic device of the present invention, a solvent may be additionally incorporated in the solution to be used in the applying step. The cross-linking agent may serve also as the solvent depending on the kind of the cross-linking agent.

A preferable second method of forming a cross-linked site in the method of manufacturing an electronic device of the present invention is a method involving chemically bonding the functional groups together.

By doing so, the structure of the cross-linked site is determined by functional groups bonded in advance to carbon nanotubes. Therefore, the size of the cross-linked site for bonding the carbon nanotubes together becomes constant. Since a carbon nanotube has an extremely stable chemical structure, there is a low possibility that functional groups and the like other than a functional group to modify the carbon nanotube are bonded to the carbon nanotube. In the case where the functional groups are chemically bonded together, the designed structure of the cross-linked site can be obtained, thereby providing a homogeneous carbon nanotube structure.

Furthermore, the functional groups are chemically bonded together, so the length of the cross-linked site between the carbon nanotubes can be shorter than that in the case where the functional groups are cross-linked together with a cross-linking agent interposed therebetween. Therefore, the carbon nanotube structure is dense, and can be easily made homogeneous.

A reaction for chemically bonding the functional groups together is particularly preferably condensation, a substitution reaction, an addition reaction, or an oxidation reaction.

In the method of manufacturing an electronic device of the present invention, the functional groups are preferably: at least one selected from the group consisting of -COOR (where R represents a substituted or unsubstituted hydrocarbon group), -COOH, -COX (where X represents a halogen atom), -OH, -CHO, and -NH₂ for a condensation reaction; at least one selected from the group consisting of -NH₂, -X (where X represents a halogen atom), -SH, -OH, -OSO₂CH₃, and -OSO₂(C₆H₄)CH₃ for a substitution reaction; at least one selected from the group consisting of -OH and -NCO for an addition reaction; and -SH for an oxidation reaction.

In particular, in the electronic device of the present invention, molecules containing the above functional groups may be bonded to carbon nanotubes and chemically bonded at functional group portions listed above to construct a cross-linked site.

Examples of the functional groups particularly preferable for use in the condensation reaction include -COOH. Introduction of a carboxyl group into carbon nanotubes is relatively easy, and the resultant substance (carbon nanotube carboxylic acid) has high reactivity. Therefore, functional groups for forming a network structure can be easily introduced into multiple sites of one carbon nanotube. Moreover, the functional groups are suitable for formation of an applied film because the functional groups easily prompt a condensation reaction.

In addition, a solution for producing the carbon nanotube structure of the present invention is characterized by containing: a plurality of carbon nanotubes each having functional groups; and an additive for bonding the functional groups of the different carbon nanotubes together.

A network-like and homogeneous carbon nanotube structure can be produced with extreme ease of handling by using the solution of the present invention. It is essential to use a condensation agent as the additive when a condensation reaction is adopted or to use a base as the additive when a substitution reaction is adopted. An oxidation reaction accelerator is desirably used as the additive when an oxidation reaction is adopted. In addition, a reaction accelerator or the like is not always needed in an addition reaction. The additive may be mixed with the solution in advance or may be mixed immediately before use.

In the method of manufacturing an electronic device of the present invention, the carbon nanotube structure layer is more preferably patterned into a shape corresponding to the transporting layer to provide for a patterning step. In this stage, the structure itself of the carbon nanotube structure layer has already been stabilized in the above cross-linking step. Since patterning is performed in this state, such inconvenience as scattering of a carbon nanotube in the patterning step may not occur, so the layer can be patterned into a pattern corresponding to the transporting layer. In addition, the carbon nanotube structure layer itself is structured, so connection between the carbon nanotubes is surely ensured and an electrical path can be stably formed. In addition, in the carbon nanotube structure, a plurality of functional groups are chemically bonded together to mutually cross-link a plurality of carbon nanotubes together. As a result, across-linkedsitecanbeuniformly formed in the entire structure without dependence on accidental contact unlike the carbon nanotube dispersion film. Therefore, even after a large carbon nanotube structure after undergoing the cross-linking step is patterned into a smaller size, an electrical path can be stably ensured, and a homogeneous electronic device can be formed.

Each of the following two modes A and B can be given as the patterning step.
A: Amode in which the patterning step is a step involving: subjecting a carbon nanotube structure layer in a region having a pattern other than a pattern corresponding to the transporting layer on the base body surface to dry etching to remove the carbon nanotube structure layer in the region; and patterning the carbon nanotube structure layer into the pattern corresponding to the transporting layer.
   A mode can be given as an operation of patterning the carbon nanotube structure layer into the pattern corresponding to the transporting layer, in which the patterning step is further divided into two steps: a resist layer forming step of forming a resist layer (preferably a resin layer) on the carbon nanotube structure layer in the region having the pattern corresponding to the transporting layer on the base body surface, and a removing step of removing a carbon nanotube structure layer exposed in a region other than the region by subjecting a surface of the base body on which the carbon nanotube structure layer and the resist layer are laminated to dry etching (preferably by irradiating the surface with a radical of an oxygen molecule which can be generated by irradiating the oxygen molecule with ultraviolet light to be used). In this case, subsequent to the removing step, a resist layer peeling-off step of peeling off the resist layer formed in the resist layer forming step is further included. As a result, the patterned carbon nanotube structure layer can be exposed.
   In addition, in the mode described above, a mode can be given as the operation of patterning the carbon nanotube structure layer into the pattern corresponding to the transporting layer, in which the carbon nanotube structure layer in the region having a pattern other than the pattern corresponding to the transporting layer on the base body surface is selectively irradiated with an ion of a gas molecule in the form of an ion beam to remove the carbon nanotube structure layer in the region thereby patterning the carbon nanotube structure layer into the pattern corresponding to the transporting layer.
B: A mode in which the patterning step is a step including:
   a resist layer forming step of forming a resist layer on the carbon nanotube structure layer in the region having the pattern corresponding to the transporting layer on the base body surface; and
   a removing step of removing a carbon nanotube structure layer exposed in a region other than the region by bringing a surface of the base body on which the carbon nanotube structure layer and the resist layer are laminated into contact with an etchant.
      In the method of manufacturing an electronic device of the present invention, when 3 electrodes are arranged in a carbon nanotube structure having a network structure in which carbon nanotubes are chemically bonded to form cross-linked sites, and one of the electrodes is used as a control electrode, it has been found that not only a single-wall carbon nanotube but also a multi-wall carbon nanotube having high productivity and high availability exhibits characteristics similar to those of a semiconductor device. This carbon nanotube is patterned after it has been structured into a network shape that can be stably patterned. As a result, high density patterning, which has been difficult in a contact state, can be performed without reliance on accidental contact between carbon nanotubes. Therefore, the method of manufacturing an electronic device of the present invention is a manufacturing method which is extremely excellent in productivity as compared to a conventional approach and which is suitable for forming a top-down integrated circuit because an electronic device can be assuredly and effectively obtained with the method of the present invention. The method of manufacturing an electronic device of the present invention provides an extremely revolutionary method for embodying a highly integrated device using a carbon nanotube which has been currently promising.
      As described above, according to the present invention, there can be provided an electronic device and an integrated circuit each having stable electrical characteristics. Furthermore, a uniform electronic device using a carbon nanotube can be produced with extreme efficiency.

### Brief Description of the Drawings

Fig. 1 is a schematic sectional diagram of a MOS-FET carbon nanotube field effect transistor according to an embodiment of the present invention.
Fig. 2 is a schematic diagram of the MOS-FET carbon nanotube field effect transistor shown in Fig. 1 when viewed from the above.
Fig. 3 is a schematic sectional diagram of a MES-FET carbon nanotube field effect transistor according to an embodiment of the present invention.
Fig. 4(1) is a schematic sectional diagram of the surface of a base body showing a state during a manufacturing process for explaining an example of a method of manufacturing an electronic device of the present invention, showing a state where nothing is formed on the substrate.

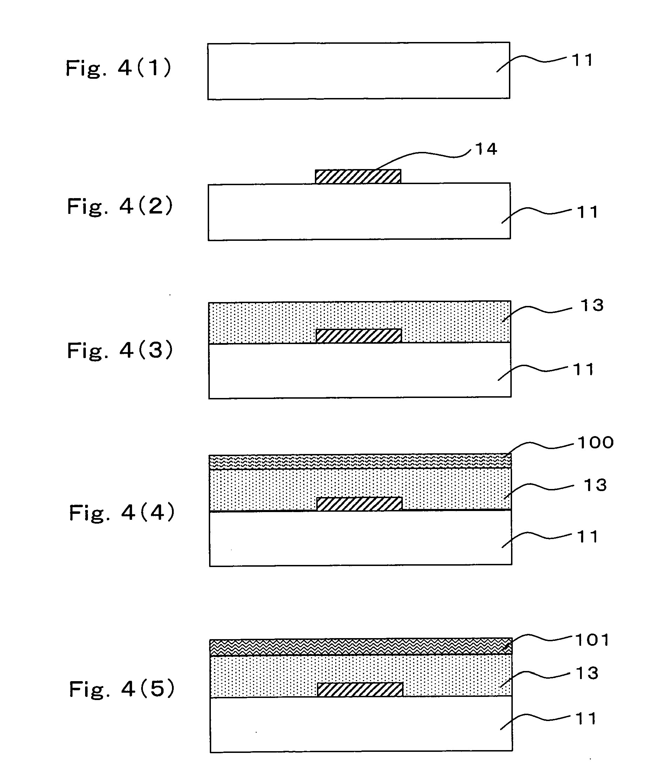

Fig. 4 (2) is a schematic sectional diagram of the surface of the base body showing a state during the manufacturing process for explaining the example of the method of manufacturing an electronic device of the present invention, showing a state where a gate electrode has been formed on the substrate.
Fig. 4 (3) is a schematic sectional diagram of the surface of the base body showing a state during the manufacturing process for explaining the example of the method of manufacturing an electronic device of the present invention, showing a state where a gate insulating film has been formed on the substrate.
Fig. 4 (4) is a schematic sectional diagram of the surface of the base body showing a state during the manufacturing process for explaining the example of the method of manufacturing an electronic device of the present invention, showing a state after a supplying step.
Fig. 4 (5) is a schematic sectional diagram of the surface of the base body showing a state during the manufacturing process for explaining the example of the method of manufacturing an electronic device of the present invention, showing a state after a cross-linking step.

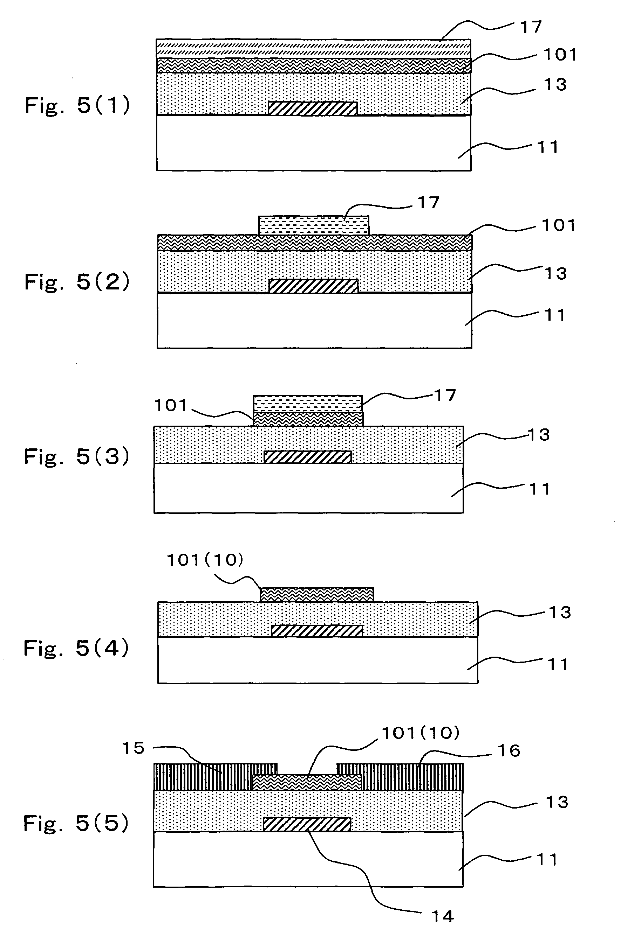

Fig. 5(6) is a schematic sectional diagram of the surface of the base body showing a state during the manufacturing process for explaining the example of the method of manufacturing an electronic device of the present invention, showing a state where a resist layer has been formed on the entire surface with a carbon nanotube structure layer formed, during a patterning step after the steps shown in Figs. 4.
Fig. 5 (7) is a schematic sectional diagram of the surface of the base body showing a state during the manufacturing process for explaining the example of the method of manufacturing an electronic device of the present invention, showing a state of the substrate after undergoing a resist layer forming step, during the patterning step after the steps shown in Figs. 4.
Fig. 5 (8) is a schematic sectional diagram of the surface of the base body showing a state during the manufacturing process for explaining the example of the method of manufacturing an electronic device of the present invention, showing a state of the substrate after undergoing a removing step, during the patterning step after the steps shown in Figs. 4.
Fig. 5 (9) is a schematic sectional diagram of the surface of the base body showing a state during the manufacturing process for explaining the example of the method of manufacturing an electronic device of the present invention, showing a state of the substrate after undergoing a resist layer peeling-off step, during the patterning step after the steps shown in Figs. 4.
Fig. 5(10) is a schematic sectional diagram of the surface of the base body showing a state during the manufacturing process for explaining the example of the method of manufacturing an electronic device of the present invention, showing a state of the substrate after undergoing a step of forming source and drain electrodes.

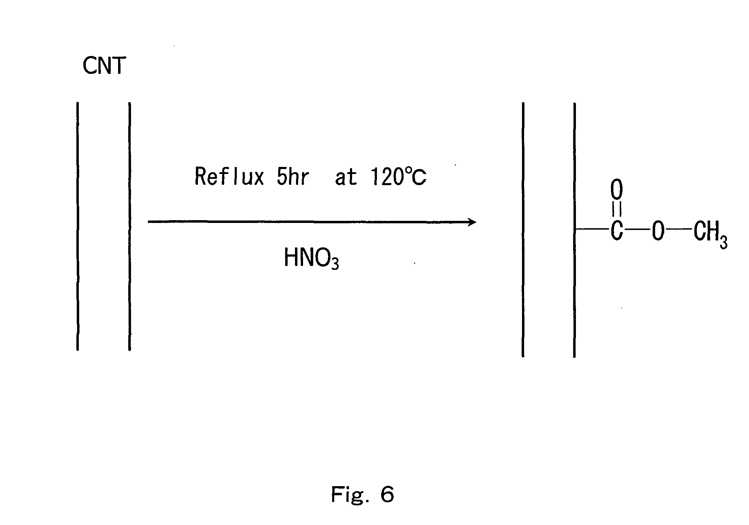

Fig. 6 is a reaction scheme for the synthesis of a carbon nanotube carboxylic acid in (Addition Step) of Example 1.

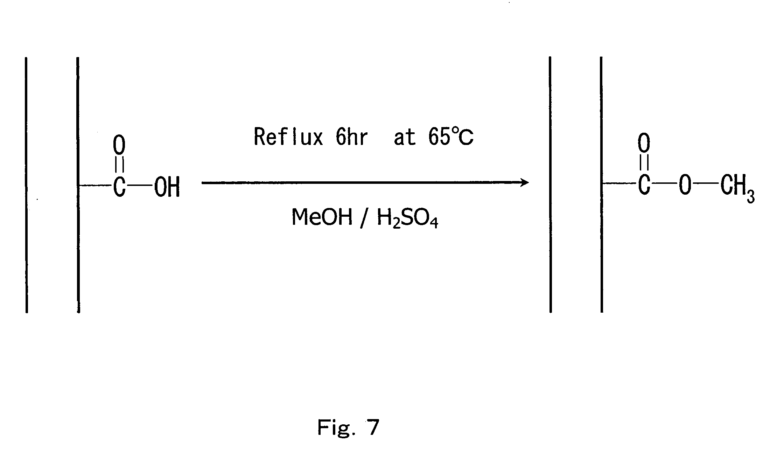

Fig. 7 is a reaction scheme for esterification in (Addition Step) of Example 1.

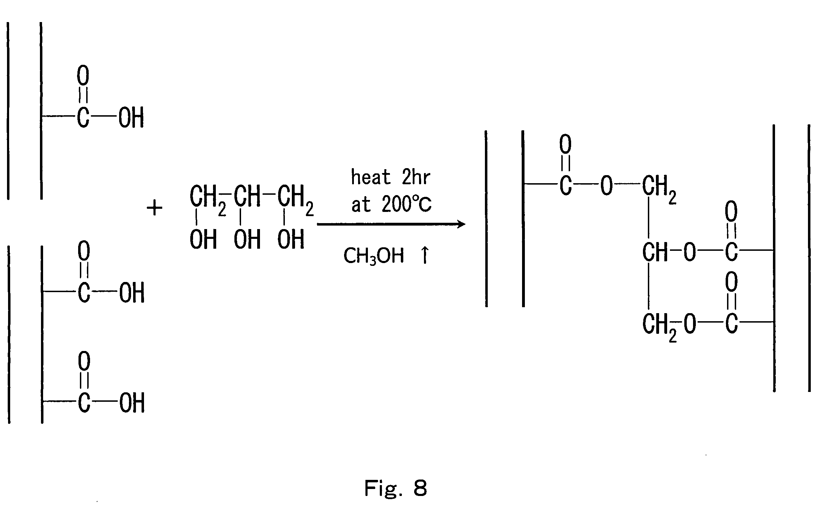

Fig. 8 is a reaction scheme for cross-linking by an ester exchange reaction in (Cross-linking Step) of Example 1.

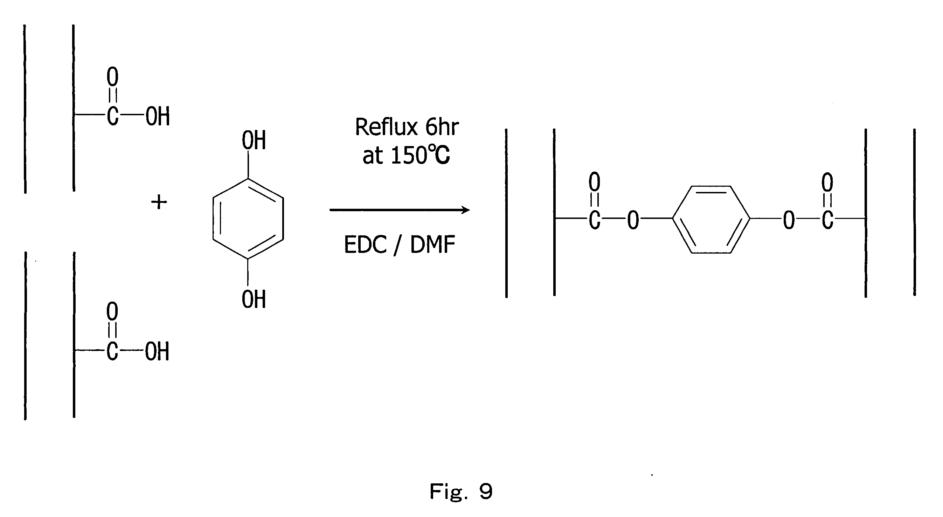

Fig. 9 is a reaction scheme for cross-linking by an ester exchange reaction in (Cross-linking Step) of Example 3.

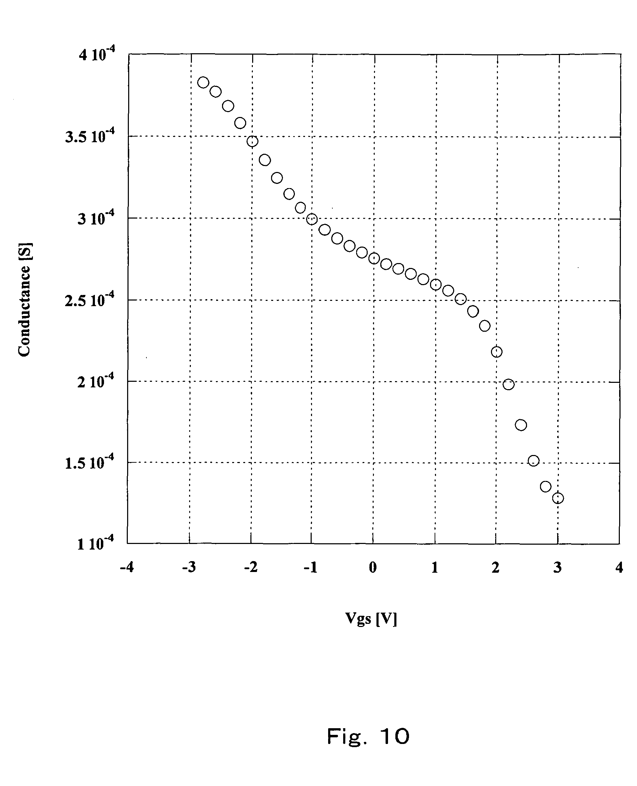

Fig. 10 is a graph showing a change in conductance between a source and a drain with a gate voltage in an electronic device using a carbon nanotube structure constituted by a single-wall carbon nanotube produced in Example 1 and glycerin.

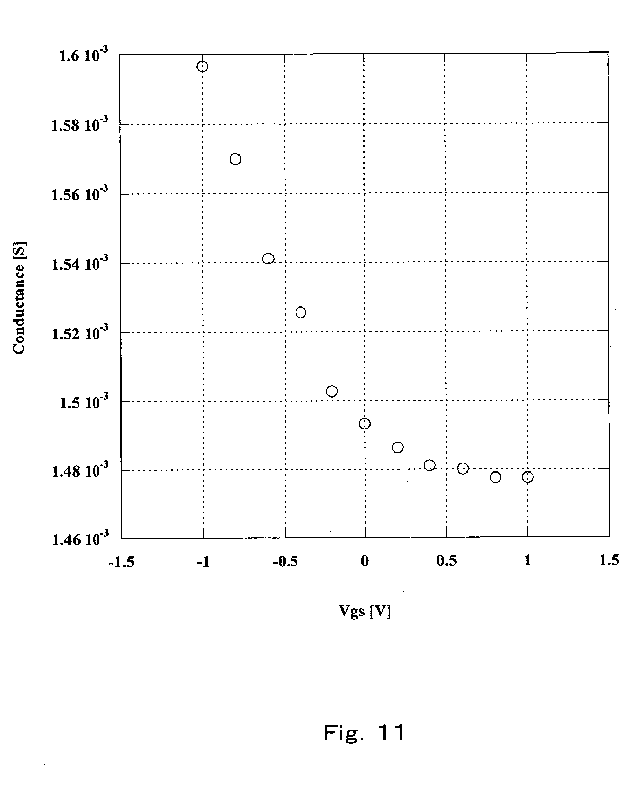

Fig. 11 is a graph showing a change in conductance between a source and a drain with a gate voltage in an electronic device using a carbon nanotube structure constituted by a single-wall carbon nanotube produced in Example 2 and glycerin.

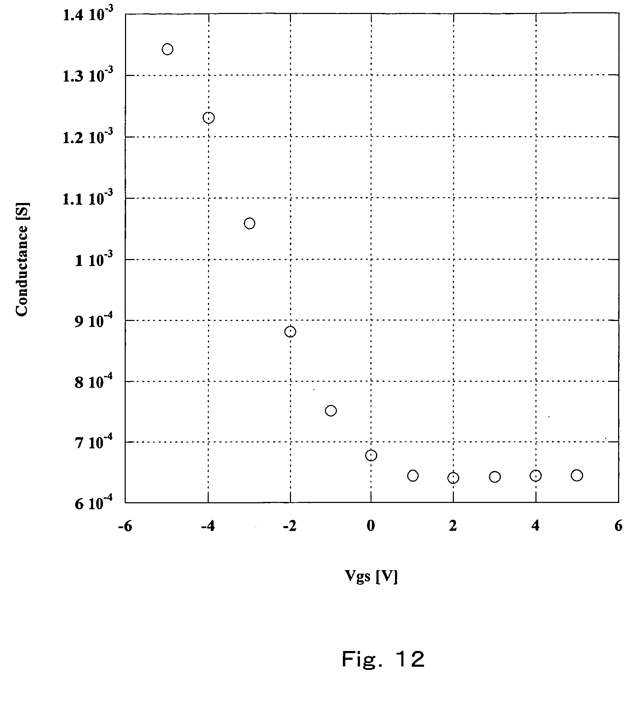

Fig. 12 is a graph showing a change in conductance between a source and a drain with a gate voltage in an electronic device using a carbon nanotube structure constituted by a multi-wall carbon nanotube produced in Example 3 and 1,4-hydroquinone.

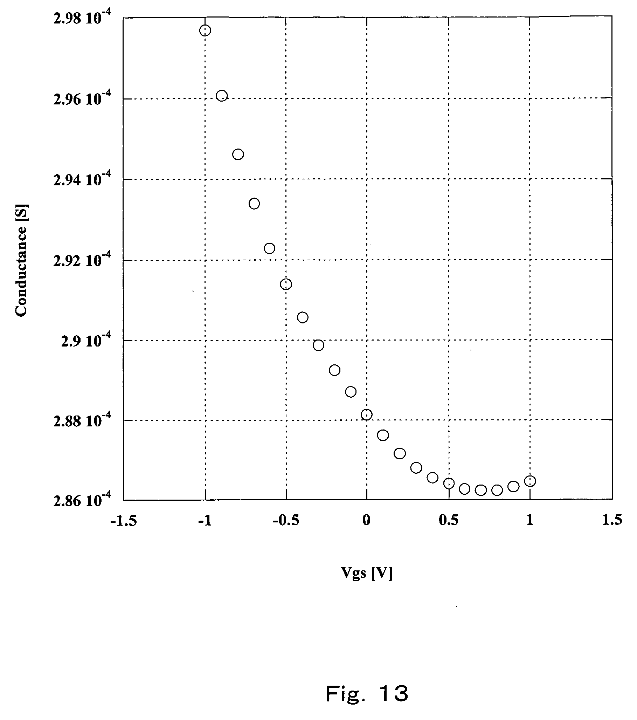

Fig. 13 is a graph showing a change in conductance between a source and a drain with a gate voltage in an electronic device using a carbon nanotube structure constituted by a multi-wall carbon nanotube produced in Example 4 and 1,4-hydroquinone.

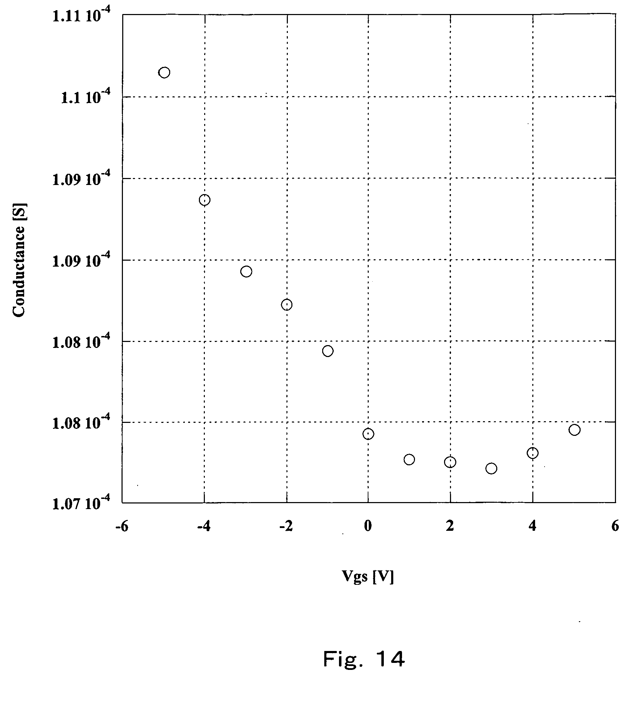

Fig. 14 is a graph showing a change in conductance between a source and a drain with a gate voltage in an electronic device using a carbon nanotube structure constituted by a multi-wall carbon nanotube produced in Example 5 and glycerin.

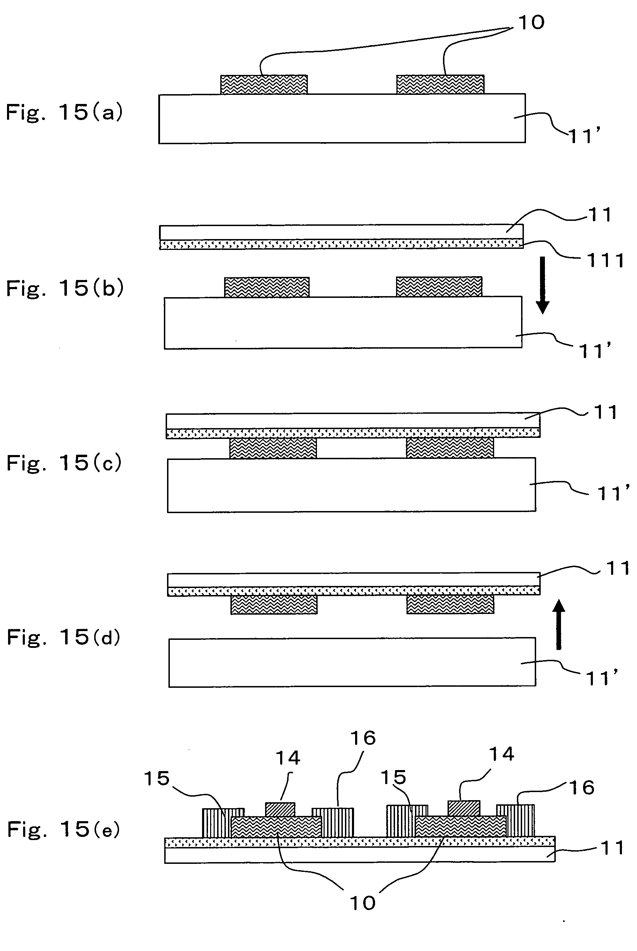

Fig. 15(a) is a schematic sectional diagram of the surface of a base body for explaining an applied example of the method of manufacturing an electronic device of the present invention, showing a state after forming a carbon nanotube structure and patterning it into a shape corresponding to a transporting layer.
Fig. 15(b) is a schematic sectional diagram of the surface of the base body for explaining the applied example of the method of manufacturing an electronic device of the present invention, showing a state before attachment of a temporary substrate to the substrate shown in Fig. 15(a).
Fig. 15(c) is a schematic sectional diagram of the surface of the base body for explaining the applied example of the method of manufacturing an electronic device of the present invention, showing a state after attachment of the temporary substrate to the substrate shown in Fig. 15(a).
Fig. 15(d) is a schematic sectional diagram of the surface of the base body for explaining the applied example of the method of manufacturing an electronic device of the present invention, showing a state after peeling off the temporary substrate attached to the substrate shown in Fig. 15(a).
Fig. 15(d) is a schematic sectional diagram of the surface of the base body for explaining the applied example of the method of manufacturing an electronic device of the present invention, showing a state where two top gate MES-FET's are finally formed at the same time.

### Best Mode for carrying out the Invention

Hereinafter, an electronic device of the present invention and a method of manufacturing the same of the present invention will be described.

### [Electronic Device]

A transistor, which is a typical active electronic device, is generally composed of a source electrode and a drain electrode connected to a transporting layer, and a gate arranged to allow an electric field to be applied to the transporting layer. A current between the source electrode and the drain electrode is controlled or amplified by applying a voltage to the gate electrode. In addition, a structure having an insulating film formed between a gate electrode and a transporting layer is referred to as a MOS-FET (Metal Oxside Semiconductor Field Effect Transistor), which is used for a transistor using silicon for a transporting layer. In addition, a structure having no insulating film between the gate electrode and the transporting layer is referred to as a MES-FET (Metal Semiconductor Field Effect Transistor), which is used for a transistor using gallium arsenide for a transporting layer.

A field effect transistor according to an embodiment of the present invention has a transporting layer constituted by a carbon nanotube structure layer having a network structure in which carbon nanotubes mutually cross-link.

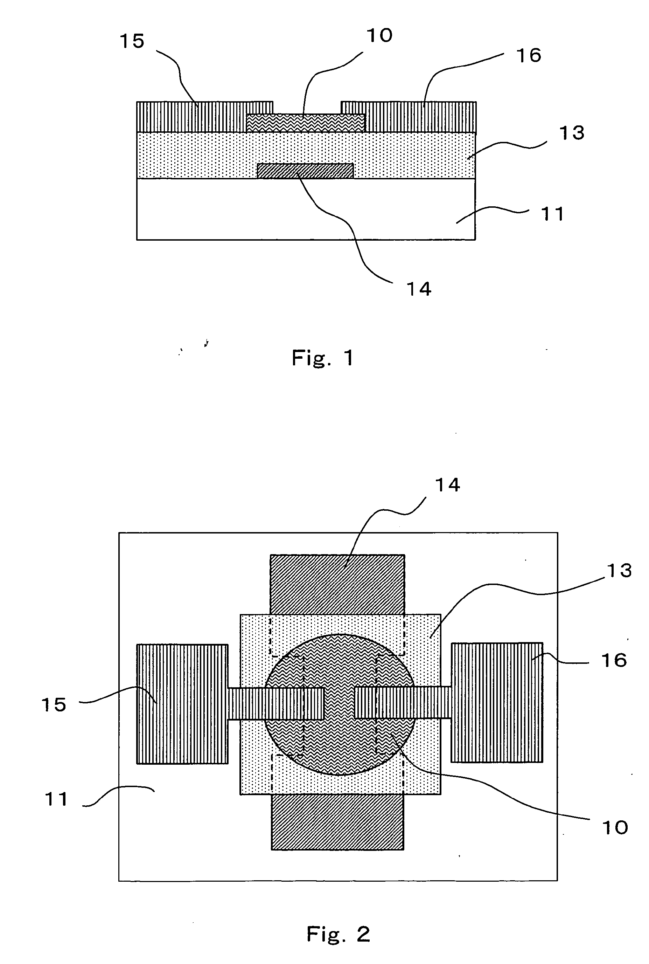

An example in which a MOS-FET (metal oxide semiconductor field effect transistor) thin film transistor, which is an embodiment of the present invention, is structured will be described with reference to Fig. 1 and Fig. 2.

Fig. 1 is a side view showing a MOS-FET carbon nanotube transistor according to this embodiment, and Fig. 2 is a top view of the transistor. The carbon nanotube transistor is constituted by a gate electrode 14, a gate insulating film 13 composed of SiO₂, a transporting layer 10, a source electrode 15, and a drain electrode 16, which are sequentially laminated on a silicon substrate 11.

The transporting layer 10 is constituted by a carbon nanotube structure formed into a network structure via cross-linked sites in each of which a plurality of carbon nanotubes cross-link, and each cross-linked site is formed by chemical bonding. A method of forming the carbon nanotube structure will be described later.

3 electrodes are arranged on the transporting layer constituted by a carbon nanotube structure formed into a network structure via cross-linked sites each formed by chemical bonding, a current is allowed to flow between the source and the drain, and a gate voltage is applied thereto, with the result that a controlling effect on the current is exerted.

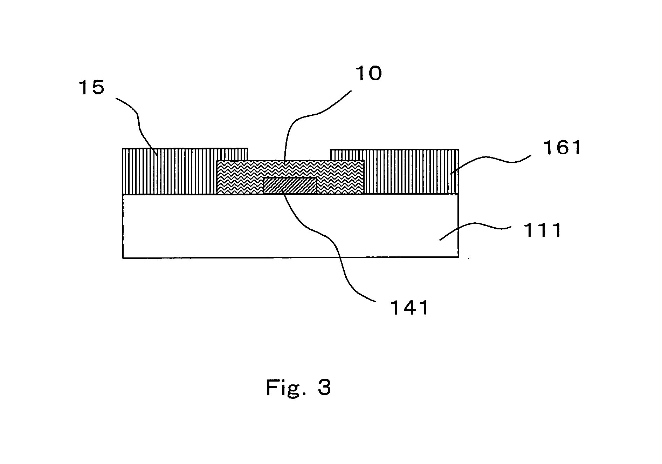

In addition, a MES-FET (metal semiconductor field effect transistor) may be adopted as another embodiment of the present invention. Fig. 3 shows a side view of a MES-FET carbon nanotube transistor. Fig. 3 differs from Fig. 1 in that a transporting layer constituted by the carbon nanotube structure and a gate electrode are laminated without the gate insulating film 13 interposed between them. Other features are the same as those of the MOS-FET, and description thereof will be omitted. Even in this configuration, a current between a source and a drain can be controlled by applying a voltage to a control electrode.

Examples of an available transistor structure include a multigate structure having a plurality of gate electrodes and a structure in which a gate electrode is three-dimensionally structured to make an effect of an electric field on a transporting layer effective. With regard to the arrangement of a gate electrode, any one of various structures such as a top gate structure and a bottom gate structure may be adopted.

### (Electrode)

An electrode to be used for the electronic device of the present invention has only to be conductive, and examples of such an electrode include: various metal electrodes made of gold, aluminum, copper, platinum, and the like; and electrodes made of organic materials such as conductive polymers. In general, in a semiconductor device using a semiconductor crystal, it may be difficult to form a transporting layer on an electrode owing to the crystal growth. However, the transporting layer of the present invention is free of such a constraint because it is a carbon nanotube structure. However, from the viewpoint of wettability of an application solution at the time of application, it is preferable to select an electrode material in accordance with the application solution or to subject the electrode to surface treatment for enhancing wettability.

Any one of conventionally used methods can be used as a method of forming an electrode, and examples of the methods include: a method involving deposition by means of a mask; a method involving the use of photolithography; and electrodeposition.

A material for a base body is not particularly limited, but in order to carry a transporting layer of an electronic device, it is preferable to use silicon, a quartz substrate, mica, quartz glass, or the like to facilitate a patterning process.

However, it may be impossible to pattern a carbon nanotube structure layer directly on the surface of a base body depending on the shape and nature of the base body. In such a case, it is sufficient that a base body carrying a patterned carbon nanotube structure layer be attached to a second base body before use, or that a patterned carbon nanotube structure layer be transferred. By doing so, limitations to be placed on a final substrate carrying an electronic device are mitigated.

In particular, the electronic device of the present invention can be easily manufactured as described below even when a substrate having plasticity or flexibility is used as a base body. In addition, the carbon nanotube structure layer formed on the surface of the base body has a cross-linking structure. Therefore, even if the substrate is bent for deformation, the carbon nanotube structure layer on the surface hardly ruptures, with the result that the deterioration of the performance of the device due to deformation is reduced. In particular, in the case where the carbon nanotube device is used as an electronic device, the occurrence of a defect of an electrical path due to bending is reduced.

Examples of the substrate having plasticity or flexibility include various resins such as polyethylene, polypropylene, polyvinyl chloride, polyamide, and polyimide.

### <Carbon Nanotube Structure Layer>

In the present invention, the term "carbon nanotube structure layer" refers to a structure formed into a network structure by a plurality of carbon nanotubes and cross-linked sites each formed by chemical bonding of different carbon nanotubes. The carbon nanotube structure layer may be formed according to any method as long as a structure of carbon nanotubes in which carbon nanotubes mutually cross-link through chemical bonding to construct a network structure can be formed. However, the carbon nanotube structure is preferably formed according to the method of manufacturing an electronic device of the present invention to be described later because the structure can be easily manufactured, a low-cost and high-performance transporting layer can be obtained, and the uniformization and control of characteristics can be easily performed.

The carbon nanotube structure to be used as a transporting layer in the electronic device of the present invention manufactured according to the method of manufacturing an electronic device of the present invention is obtained by: curing a solution (cross-linking application solution) containing carbon nanotubes having functional groups and a cross-linking agent which prompts a cross-linking reaction with the functional groups; and subjecting the functional groups of the carbon nanotubes and the cross-linking agent to a cross-linking reaction to form a cross-linked site.

Hereinafter, the carbon nanotube structure layer in the electronic device of the present invention will be described by taking the manufacturing method as an example.

### (Carbon Nanotube)

Carbon nanotubes, which are the main component in the present invention, may be single-wall carbon nanotubes or multi-wall carbon nanotubes each having two or more layers. As described above, the inventors of the present invention have found that, when a carbon nanotube structure is formed as in the present invention and is used as a transporting layer, a current controlling effect is exerted by combination of 3 electrodes regardless of whether each carbon nanotube is a single-wall carbon nanotube or a multi-wall carbon nanotube. Therefore, Whether one or both types of carbon nanotubes are used (and, if only one type is to be used, which type is selected) or both of them are mixed may be decided appropriately by taking into consideration the use and characteristics of the electronic device, or the cost.

Carbon nanotubes in the present invention include ones that are not exactly shaped like a tube, such as: a carbon nanohorn (a horn-shaped carbon nanotube whose diameter continuously increases from one end toward the other end) which is a variant of a single-wall carbon nanotube; a carbon nanocoil (a coil-shaped carbon nanotube forming a spiral when viewed in entirety); a carbon nanobead (a spherical bead made of amorphous carbon or the like with its center pierced by a tube); a cup-stacked nanotube; and a carbon nanotube with its circumference covered with a carbon nanohorn or amorphous carbon.

Furthermore, carbon nanotubes in the present invention may be ones that contain some substances inside, such as: a metal-containing nanotube which is a carbon nanotube containing metal or the like; and a peapod nanotube which is a carbon nanotube containing a fullerene or a metal-containing fullerene.

As described above, in the present invention, it is possible to employ carbon nanotubes of any mode, including common carbon nanotubes, variants of common carbon nanotubes, and carbon nanotubes with various modifications, without a problem in terms of reactivity. Therefore, the concept of "carbon nanotube" in the present invention encompasses all of the above.

Those carbon nanotubes are conventionally synthesized by a known method, such as arc discharge, laser ablation, and CVD, and the present invention can employ any of the methods. However, arc discharge in a magnetic field is preferable from the viewpoint of synthesizing a highly pure carbon nanotube.

Carbon nanotubes used in the present invention are preferably equal to and more than 0.3 nm and equal to or less than 100 nm in diameter. If the diameter of the carbon nanotubes exceeds this range, the synthesis becomes difficult and costly. A more desirable upper limit of the diameter of the carbon nanotubes is 30 nm or less.

In general, the lower limit of the carbon nanotube diameter is about 0.3 nm from a structural standpoint. However, too thin a diameter could lower the synthesis yield. It is therefore preferable to set the lower limit of the carbon nanotube diameter to 1 nm or more, more preferably 10 nm or more.

The length of carbon nanotubes used in the present invention is preferably equal to or more than 0.1 µm and equal to or less than 100 µm. If the length of the carbon nanotubes exceeds this range, the synthesis becomes difficult or requires a special method raising cost, which is not preferable. On the other hand, if the length of the carbon nanotubes falls short of this lower limit, the number of cross-link bonding points per carbon nanotube is reduced, which is not preferable. A more preferable upper limit of the carbon nanotube length is 10 µm or less and a more preferable lower limit of the carbon nanotube length is 1 µm or more.

The appropriate carbon nanotube content in the cross-linking application solution varies depending on the length and thickness of carbon nanotubes, whether single-wall carbon nanotubes or multi-wall carbon nanotubes are used, the type and amount of functional groups in the carbon nanotubes, the type and amount of cross-linking agents, the presence or absence of a solvent or other additive used and, if one is used, the type and amount of the solvent or additive, etc. The carbon nanotube content in the solution should be high enough to form an excellent applied film after curing but not be excessively high because the application suitability lowers.

Specifically, the ratio of carbon nanotubes to the entire application solution excluding the mass of the functional groups is in the range of about 0.01 to 10 g/l, preferably about 0.1 to 5 g/l, and more preferably about 0.5 to 1. 5 g/l, although, as mentioned above, the ranges could be different if the parameters are different.

If the purity of carbon nanotubes to be used is not high enough, it is desirable to raise the purity by prerefining the carbon nanotubes prior to preparation of the cross-linking application solution. In the present invention, the higher the carbon nanotube purity, the better the result can be. Specifically, the purity is preferably 90% or higher, more desirably, 95% or higher. When the purity is low, cross-linking agents are cross-linked to carbon products such as amorphous carbon and tar, which are impurities. This could change the cross-linking distance between carbon nanotubes, leading to a failure in obtaining desired characteristics. No particular limitation is put on how carbon nanotubes are refined, and any known conventional refining method can be employed.

### (Functional Group)

In the present invention, carbon nanotubes can have any functional group to be connected thereto without particular limitation, as long as functional groups selected can be added to the carbon nanotubes chemically and can chemically bond functional groups.

### (Functional Group 1)

A preferable first method of forming a cross-linked site is one involving the occurrence of a cross-linking reaction between functional groups by means of a certain kind of cross-linking agent. Specific examples of such functional groups include -COOR, -COX, -MgX, -X (where X represents halogen), -OR, -NR¹R², -NCO, -NCS, -COOH, -OH, -NH₂, -SH, -SO₃H, -R'CHOH, -CHO, -CN, -COSH, -SR, -SiR'₃ (where R, R¹, R², and R' each independently represent a substituted or unsubstituted hydrocarbon group). Note that employable functional groups are not limited to those examples.

Of those, it is preferable to use at least one functional group selected from the group consisting of -OH, -COOH, -COOR (where R represents a substituted or unsubstituted hydrocarbon group), -COX (where X represents a halogen atom), -NH₂, and -NCO. In that case, a cross-linking agent, which can prompt a cross-linking reaction with the selected functional group, is selected as the cross-linking agent.

In particular, -COOR (where R represents a substituted or unsubstituted hydrocarbon group) is particularly preferable. This is because a carboxyl group can be relatively easily introduced into a carbon nanotube, because the resultant substance (a carbon nanotube carboxylic acid) can be easily introduced as a functional group by esterifying the substance, and because the substance has good reactivity with a cross-linking agent.

R in the functional group -COOR is a substituted or unsubstituted hydrocarbon group, and is not particularly limited. However, R is preferably an alkyl group having 1 to 10 carbon atoms, more preferably an alkyl group having 1 to 5 carbon atoms, and particularly preferably a methyl group or an ethyl group in terms of reactivity, solubility, viscosity, and ease of use as a solvent of a paint.

The appropriate amount of functional groups introduced varies depending on the length and thickness of carbon nanotubes, whether single-wall carbon nanotubes or multi-wall carbon nanotubes are used, the types of functional groups, the use of the electronic device, etc. From the viewpoint of the strength of the cross-linked substance obtained, namely, the strength of the applied film, a preferable amount of functional groups introduced is large enough to add two or more functional groups to each carbon nanotube.

How functional groups are introduced into carbon nanotubes will be explained in the section below titled [Method of Manufacturing an Electronic Device].

### (Cross-linking Agent)

Any cross-linking agent, which is an essential ingredient of the cross-linking application solution, can be used as long as the cross-linking agent is capable of prompting a cross-linking reaction with the functional groups of the carbon nanotubes. In other words, the types of cross-linking agents that can be selected are limited to a certain degree by the types of the functional groups. Also, the conditions of curing (heating, UV irradiation, irradiation with visible light, natural curing, etc.) as a result of the cross-linking reaction are naturally determined by the combination of those parameters.

Specific examples of the preferable cross-linking agents include a polyol, a polyamine, a polycarboxylic acid, a polycarboxylate, a polycarboxylic acid halide, a polycarbodiimide, a polyisocyanate, and hydroquinone. It is desirable to use at least one cross-lining agent selected from the group consisting of the above. In that case, a functional group which can prompt a cross-linking reaction with the cross-linking agent is selected as the functional group.

At least one functional group and one cross-linking agent are particularly preferably selected respectively from the group consisting of functional groups exemplified as the preferable functional group and the group consisting of cross-linking agents exemplified as the preferable cross-linking agent, so a combination of the functional group and the cross-linking agent may prompt a cross-linking reaction with each other. Table 1 below lists the combinations of the functional group of the carbon nanotubes and the corresponding cross-linking agent, which can prompt a cross-linking reaction, along with curing conditions of the combinations.

**Table 1**

| Functional group of carbon nanotube | Cross-linking agent | Curing condition |
|---|---|---|
| -COOR | Polyol | heat curing |
| -COX | Polyol | heat curing |
| -COOH | Polyamine | heat curing |
| -COX | Polyamine | heat curing |
| -OH | Polycarboxylate | heat curing |
| -OH | Polycarboxylic acid halide | heat curing |
| -NH₂ | Polycarboxylic acid | heat curing |
| -NH₂ | Polycarboxylic acid halide | heat curing |
| -COOH | Polycarbodiimide | heat curing |
| -OH | Polycarbodiimide | heat curing |
| -NH₂ | Polycarbodiimide | heat curing |
| -NCO | Polyol | heat curing |
| -OH | Polyisocyanate | heat curing |
| -COOH | Ammonium complex | heat curing |
| -COOH | Hydroquinone | heat curing |

| | | |
|---|---|---|
| *where R represents a substituted or unsubstituted hydrocarbon group *where X represents a halogen | | |

Of those combinations, preferable is the combination of -COOR (where R represents a substituted or unsubstituted hydrocarbon group) with good reactivity on a functional group side and a polyol which forms a robust cross-linked substance with ease. The term "polyol" used in the present invention is a generic name for organic compounds each having two or more OH groups. Of those, one having 2 to 10 (more preferably 2 to 5) carbon atoms and 2 to 22 (more preferably 2 to 5) OH groups is preferable in terms of cross-linkability, solvent compatibiity when an excessive amount thereof is charged, processability of waste liquid after a reaction by virtue of biodegradability (environment aptitude), yield of polyol synthesis, and so on. In particular, the number of carbon atoms is preferably lower within the above range because a gap between carbon nanotubes in the resultant applied film can be narrowed to bring the carbon nanotubes into substantial contact with each other (to bring the carbon nanotubes close to each other) . Specifically, glycerin and ethylene glycol are particularly preferable, and it is preferable to use one or both of glycerin and ethylene glycol as a cross-linking agent.

Depending on the cross-linking substance to be used, the electric conductivity may reduce owing to an increase in amount of a current used in the resultant electronic device. For example, a carbon nanotube structure in which multi-wall carbon nanotubes to which carboxyl groups are bonded are cross-linked via glycerin shows such a tendency. Therefore, a protective layer for covering a transporting layer is preferably formed in order to stably use the structure for a long period of time, or in order to use a large amount of current.

Examples of a material used for a protective layer (passivation layer) for protecting the transporting layer include: existing inorganic materials for insulating films and the like such as silicon oxide, silicon nitride, aluminum oxide, and titanium oxide, which are generally used for a semiconductor device; and insulating organic materials such as epoxy resins.

In contrast, even if no protective layer is used, when, a cross-linking agent to be used is, for example, hydroquinone, the absence of passivation may show no deterioration. Therefore, it is advantageous to use hydroquinone as a cross-linking agent in terms of long-term stability of characteristics.

From another perspective, the cross-linking agent is preferablyanon-self-polymerizable cross-linking agent. Glycerin and ethylene glycol as examples of the polyols are obviously non-self-polymerizable cross-linking agents. More generally, a prerequisite of the non-self-polymerizable cross-linking agent is to be without a pair of functional groups, which can prompt a polymerization reaction with each other, in itself. On the other hand, examples of a self-polymerizable cross-linking agent include one that has a pair of functional groups, which can prompt a polymerization reaction with each other, in itself (alkoxide, for example).

### (Functional Group 2)

It is also preferable to adopt a second approach in which a carbon nanotube structure has a network structure in which a plurality of carbon nanotubes mutually cross-link via cross-linked sites each formed by chemical bonding of the functional groups at least one end of each of which is connected to a different carbon nanotube.

In this case, carbon nanotubes can have any functional group to be connected thereto without particular limitation, as long as functional groups selected can be added to the carbon nanotubes chemically and can prompt a reaction among the functional groups by means of a certain kind of additive. Specific examples of such functional groups include -COOR, -COX, -MgX, -X (where X represents halogen), -OR, -NR¹R², -NCO, -NCS, -COOH, -OH, -NH₂, -SH, -SO₃H, -R'CHOH, -CHO, -CN, -COSH, -SR, -SiR'₃ (where R, R¹, R², and R' each independently represent a substituted or unsubstituted hydrocarbon group) . Note that employable functional groups are not limited to those examples.

In addition, it is also possible to connect a molecule containing those functional groups in part thereof to a carbon nanotube to cause chemical bonding at a preferable functional group portion exemplified above. In this case as well, a functional group having a large molecular weight to be bonded to a carbon nanotube is bonded as intended, so the length of the cross-linked site can be controlled.

### (Additive)

Any additive, which is added to the cross-linking application solution, can be used as long as the additive is capable of prompting a reaction between the functional groups of the carbon nanotubes. In other words, the types of additives that can be selected are limited to a certain degree by the types of the functional groups and the type of the reaction. Also, the conditions of curing (heating, UV irradiation, irradiation with visible light, natural curing, etc.) as a result of the reaction are naturally determined by the combination of those parameters.

### (Condensation agent)

Specific preferable examples of the additive include condensation agents such as: an acid catalyst; a dehydration condensation agent such as sulfuric acid; N-ethyl-N'-(3-dimethylaminopropyl)carbodiimide; and dicyclohexyl carbodiimide. It is preferable to select at least one condensation agent from the group consisting of the above. In that case, the functional groups, which can prompt a reaction among the functional groups with the help of the selected condensation agent, are selected as the functional groups.

### (Base)

Any base, which is an essential ingredient for a substitution reaction in the cross-linking application solution, may be selected depending on the acidity of a hydroxyl group.

Specific preferable examples of the base include sodium hydroxide, potassium hydroxide, pyridine, and sodium ethoxide. It is preferable to select at least one base from the group consisting of the above bases. In that case, functional groups, which can prompt a substitution reaction among the functional groups with the help of the selected base, are selected as the functional groups.

In particular, it is preferable to select at least two functional groups from the group consisting of the functional groups exemplified as preferable functional groups so that a combination of the selected functional groups is capable of prompting a mutual reaction. Table 2 below lists functional groups of carbon nanotubes capable of prompting a mutual cross-linking reaction and the names of corresponding reactions.

An additive is not always necessary for an addition reaction. Although an additive is not always necessary for an oxidation reaction, an oxidation reaction accelerator is preferably added. An example of the oxidation reaction accelerator that can be suitably added is iodine.

**Table 2**

| Cross-linked site | Functional group of carbon nanotube (A) | Functional group of carbon nanotube (B) | Reaction |
|---|---|---|---|
| -COOCO- | -COOH | - | Dehydration condensation |
| -S-S- | -SH | - | Oxidation reaction |
| -O- | -OH | - | Dehydration condensation |
| -NH-CO- | -COOH | -NH₂ | Dehydration condensation |
| -COO- | -COOH | -OH | Dehydration condensation |
| -COO- | -COOR | -OH | Dehydration condensation |
| -COO- | -COX | -OH | Dehydration condensation |
| -CH=N- | -CHO | -NH₂ | Dehydration condensation |
| -NH- | -NH₂ | -X | Substitution reaction |
| -S- | -SH | -X | Substitution reaction |
| -O- | -OH | -X | Substitution reaction |
| -O- | -OH | -OSO₂CH₃ | Substitution reaction |
| -O- | -OH | -OSO₂(C₆H₄)CH₃ | Substitution reaction |
| -NH-COO- | -OH | -N=C=O | Addition reaction |

| | | | |
|---|---|---|---|
| *R represents a substituted or unsubstituted hydrocarbon group | | | |
| *X represents a halogen | | | |

The content of a cross-linking agent or an additive for bonding functional groups in the cross-linking application solution varies depending on the type of the cross-linking agent (including whether the cross-linking agent is self-polymerizable or not self-polymerizable) and the type of the additive for bonding functional groups. The content also varies depending on the length and thickness of a carbon nanotube, whether the carbon nanotube is of a single-wall type or a multi-wall type, the type and amount of a functional group of the carbon nanotube, the presence or absence of a solvent or other additives, and, if one is used, the type and amount thereof, and the like. Therefore, the content cannot be determined uniquely. In particular, for example, glycerin or ethylene glycol can also provide characteristics of a solvent because a viscosity of glycerin or ethylene glycol is not so high, and thus an excessive amount of glycerin or ethylene glycol can be added.

### (Other Additive)

The cross-linking application solution may contain various additives including a solvent, a viscosity adjuster, a dispersant, and a cross-linking accelerator.

A solvent is added when satisfactory application suitability of the cross-linking application solution is not achieved with solely the cross-linking agent or the additive for bonding functional groups. A solvent that can be employed is not particularly limited, and may be appropriately selected according to the type of the cross-linking agent to be used. Specific examples of employable solvent include: organic solvents such as methanol, ethanol, isopropanol, n-propanol, butanol, methyl ethyl ketone, toluene, benzene, acetone, chloroform, methylene chloride, acetonitrile, diethyl ether, and tetrahydrofuran (THF) ; water; aqueous solutions of acids; and alkaline aqueous solutions. A solvent as such is added in an amount that is not particularly limited but determined appropriately by taking into consideration the application suitability of the cross-linking application solution.

A viscosity adjuster is added when satisfactory application suitability of the cross-linking application solution is not achieved with solely the cross-linking agent or the additive for bonding functional groups. A solvent that can be employed is not particularly limited, and may be appropriately selected according to the type of the cross-linking agent to be used. Specific examples of an employable viscosity adjuster include methanol, ethanol, isopropanol, n-propanol, butanol, methyl ethyl ketone, toluene, benzene, acetone, chloroform, methylene chloride, acetonitrile, diethyl ether, and THF.

Some of those viscosity adjusters have the function of a solvent when added in a certain amount, and it is meaningless to apparently discriminate viscosity adjusters from solvents. A viscosity adjuster as such is added in an amount that is not particularly limited but determined appropriately by taking into consideration the application suitability of the cross-linking application solution.

A dispersant is added to the cross-linking application solution in order to maintain the dispersion stability of the carbon nanotubes or the cross-linking agent, or the additive for bonding functional groups in the application solution. Various known surface-active agents, water-soluble organic solvents, water, aqueous solutions of acids, alkaline aqueous solutions, etc. can be employed as a dispersant. However, a dispersant is not always necessary since components of the coating material of the present invention have high dispersion stability by themselves. In addition, depending on the use of the applied film after the formation, the absence of a dispersant and like other impurities in the applied film may be desirable. In such a case, a dispersant is not added at all, or is added in a very small amount.

### (Method of Preparing the Cross-linking application solution)

A method of preparing a cross-linking application solution is described next. The cross-linking application solution is prepared by mixing carbon nanotubes having functional groups with a cross-linking agent that prompts a cross-linking reaction with the functional groups or an additive for chemically bonding functional groups as needed (mixing step). The mixing step may be preceded by an addition step in which the functional groups are introduced into the carbon nanotubes.

If carbon nanotubes having functional groups are starting materials, the preparation is performed simply by the mixing step operation. If normal carbon nanotubes themselves are starting materials, the preparation starts with the addition step operation.

The addition step is a step of introducing desired functional groups into carbon nanotubes. How functional groups are introduced varies depending on the type of functional group. One possible method is to add a desired functional group directly, and another possible method is to introduce a functional group that is easy to attach and then substitute the whole functional group or a part thereof or attach a different functional group to the former functional group or otherwise in order to obtain the objective functional group.

Still another method is to apply a mechanochemical force to a carbon nanotube to break or modify only a small portion of a graphene sheet on the surface of the carbon nanotube and introduce various functional groups from the broken or modified portion.

Cup-stacked carbon nanotubes, which have many defects on the surface upon manufacture, and carbon nanotubes that are formed by vapor phase growth are relatively easy to introduce functional groups. On the other hand, carbon nanotubes each having a perfect graphene sheet structure exert the carbon nanotube characteristics more effectively and are easier to control the characteristics. Consequently, it is particularly preferable to use a multi-wall carbon nanotube so that appropriate defects are as a transporting layer on its outermost layer to bond functional groups for cross-linking while the inner layers having less structural defects exert the carbon nanotube characteristics.

There is no particular limitation put on the addition step operation and any known method can be employed. Various addition methods described in Patent Document 1 may be employed in the present invention depending on the purpose.

A description is given on a method of introducing -COOR (where R represents a substituted or unsubstituted hydrocarbon group), a particularly desirable functional group among the functional groups listed in the above. To introduce -COOR (where R represents a substituted or unsubstituted hydrocarbon group) into carbon nanotubes, carboxyl groups may be (i) added to the carbon nanotubes once, and then (ii) esterified.

### (i) Addition of Carboxyl Group

To introduce carboxyl groups into carbon nanotubes, carboxyl groups are refluxed together with an acid having an oxidizing effect. This operation is relatively easy and is preferable since carboxyl groups with high reactivity are attached to carbon nanotubes. A brief description of the operation is given below.

An acid having an oxidizing effect is, for example, concentrated nitric acid, hydrogen peroxide water, a mixture of sulfuric acid and nitric acid, or aqua regia. When concentrated nitric acid is used, in particular, the concentration is preferably 5 mass% or higher, more preferably, 60 mass% or higher.

A normal reflux method can be employed. The temperature at which reflux is performed is preferably set to a level near the boiling point of the acid used. When concentrated nitric acid is used, for instance, the temperature is preferably set to 120 to 130°C. The reflux preferably lasts 30 minutes to 20 hours, more preferably, 1 hour to 8 hours.

Carbon nanotubes to which carboxyl groups are attached (a carbon nanotube carboxylic acid) are generated in the reaction liquid after the reflux. The reaction liquid is cooled down to room temperature and then receives a separation operation or washing as necessary, thereby obtaining the objective carbon nanotube carboxylic acid.

### (ii) Esterification

The target functional group -COOR (where R represents a substituted or unsubstituted hydrocarbon group) can be introduced by adding an alcohol to the obtained carbon nanotube carboxylic acid and dehydrating the mixture for esterification.

The alcohol used for the esterification is determined according to R in the formula of the functional group. That is, if R is CH₃, the alcohol is methanol, and if R is C₂H₅, the alcohol is ethanol.

A catalyst is generally used in the esterification, and a conventionally known catalyst such as sulfuric acid, hydrochloric acid, ortoluenesulfonic acid can also be used in the present invention. The use of sulfuric acid as a catalyst is preferable from a view of not prompting a side reaction in the present invention.

The esterification may be conducted by adding an alcohol and a catalyst to a carbon nanotube carboxylic acid and refluxing the mixture at an appropriate temperature for an appropriate time period. A temperature condition and a time period condition in this case depend on type of a catalyst, type of alcohol, or the like and cannot be simply determined, but a reflux temperature close to the boiling point of the alcohol used is preferable. The reflux temperature is preferably in the range of 60 to 70°C for methanol, for example. Further, a reflux time period is preferably in the range of 1 to 20 hours, more preferably in the range of 4 to 6 hours.

A carbon nanotube with the functional group -COOR (where R represents a substituted or unsubstituted hydrocarbon group) added can be obtained by separating a reaction product from a reaction solution after esterification and washing the reaction product as required.

The mixing step is a step of mixing carbon nanotubes having functional groups with a cross-linking agent prompting a cross-linking reaction with the functional groups or an additive for bonding functional groups as needed, to prepare the cross-linking application solution. In the mixing step, other components described in the aforementioned section titled [Wire] are mixed, in addition to the carbon nanotubes having functional groups and the cross-linking agents. Then, preferably, an addition amount of a solvent or a viscosity adjuster is adjusted considering application suitability to prepare the cross-linking application solution just before application to the substrate.

Simple stirring with a spatula and stirring with a stirrer of a stirring blade type, a magnetic stirrer, and a stirring pump may be used for the mixing. However, to achieve higher degree of uniformity in dispersion of the carbon nanotubes to enhance storage stability while fully extending a network structure by cross-linking of the carbon nanotubes, an ultrasonic disperser or a homogenizer may be used for powerful dispersion. However, when using a stirring device with a strong shear force of stirring such as a homogenizer, there arises a risk of cutting and damaging the carbon nanotubes in the solution, thus the device may be used for a very short time period.

A carbon nanotube structure layer is formed by applying a substrate surface with the cross-linking application solution described above and curing the substrate. An applying method and a curing method are described in detail in the section below titled [Method of Manufacturing an Electronic Device].

The carbon nanotube structure layer in the present invention is in a state where carbon nanotubes are networked. In detail, the carbon nanotube structure layer is cured into a matrix shape, carbon nanotubes are connected to each other via cross-linked sites, and characteristics of a carbon nanotube itself such as high electron- and hole-transmission characteristics can be exerted sufficiently. In other words, the carbon nanotube structure layer has carbon nanotubes that are tightly connected to each other, contains no other binders and the like, and is thus composed substantially only of carbon nanotubes, so that characteristics that are unique of a carbon nanotube are fully utilized.

A thickness of the carbon nanotube structure layer of the present invention can be widely selected from being very thin to being thick according to an application. Lowering a content of the carbon nanotubes in the cross-linking application solution used (simply, lowering the viscosity by diluting) and applying the cross-linking application solution in a thin coat form allows a very thin applied film to be obtained. Similarly, raising a content of the carbon nanotubes allows a thick applied film to be obtained. Further, repeating the application allows an even thicker applied film to be obtained. Formation of a very thin applied film from a thickness of about 10 nm is thoroughly possible, and formation of a thick applied film without an upper limit is possible through recoating. A possible coat thickness with one coating is about 5 µm.

In the transporting layer constituted by the carbon nanotube structure formed according to the first approach using a cross-linking agent, a site where the carbon nanotubes cross-link together, that is, the cross-linked site formed by a cross-linking reaction between the functional groups of the carbon nanotubes and the cross-linking agent has a cross-linking structure. In the cross-linking structure, residues of the functional group remaining after a cross-linking reaction are connected together with a connecting group, which is a residue of the cross-linking agent remaining after a cross-linking reaction.

As described, the cross-linking agent, which is a component of the cross-linking application solution, is preferably not self-polymerizable. If the cross-linking agent is not self-polymerizable, the connecting group of the carbon nanotube structure layer finally fabricated would be constructed from a residue of only one cross-linking agent. The gap between the carbon nanotubes to be cross-linked can be controlled to a size of a residue of the cross-linking agent used, thereby providing a desired network structure of the carbon nanotubes with high duplicability. Further, the cross-linking agents are not present between the carbon nanotubes, thus enabling enhancement of an actual density of the carbon nanotubes in the carbon nanotube structure. Further, reducing a size of a residue of the cross-linking agent can extremely narrow a gap between the carbon nanotubes both electrically and physically (carbon nanotubes are substantially in direct contact with each other).

When forming the carbon nanotube structure layer with a cross-linking application solution prepared by selecting a single functional group of the carbon nanotubes and a single non-self-polymerizable cross-linking agent, respectively, the cross-linked site of the layer will have the same cross-linking structure (Example 1). Further, even when forming the carbon nanotube structure layer with a cross-linking application solution prepared by selecting multiple types of functional groups of the carbon nanotubes and/or multiple types of non-self-polymerizable cross-linking agents, respectively, the cross-linked site of the layer will mainly have a cross-linking structure based on a combination of the functional group and the non-self-polymerizable cross-linking agent mainly used (Example 2).

In contrast, when forming the carbon nanotube structure layer with a cross-linking application solution prepared by selecting self-polymerizable cross-linking agents, without regard to whether the functional groups and the cross-linking agents in the carbon nanotubes are of single or multiple types, the cross-linked site of the layer where carbon nanotubes cross-link together will not mainly have a specific cross-linking structure. This is because the cross-linked site will be in a state where numerous connecting groups with different connecting (polymerization) numbers of the cross-linking agents coexist.

In other words, by selecting non-self-polymerizable cross-linking agents, the cross-linked sites of the carbon nanotube structure layer where the carbon nanotubes cross-link together bond with the functional group through a residue of only one cross-linking agent, thus forming a mainly identical cross-linking structure. "Mainly identical" here is a concept including a case with all of the cross-linked sites having an identical cross-linking structure as described above (Example 1), as well as a case with the cross-linking structure based on a combination of the functional group and the non-self-polymerizable cross-linking agent mainly used becomes a main structure with respect to the whole cross-linked site as described above (Example 2).

When referring as "mainly identical", a "ratio of identical cross-linked sites" with respect to the whole cross-linked sites will not have a uniform lower limit defined. The reason is that a case of imparting a functional group or a cross-linking structure with an aim different from formation of a carbon nanotube network may be assumed, for example, in the cross-linked sites, for example. However, in order to actualize high electrical or physical characteristics that are unique of carbon nanotubes with a strong network, a "ratio of identical cross-linked sites" with respect to the total cross-linked sites is preferably 50% or more, more preferably 70% or more, further more preferably 90% or more, and most preferably 100%, based on numbers. Those number ratios can be determined through, for example, a method of measuring an intensity ratio of an absorption spectrum corresponding to the cross-linking structure with an infrared spectrum.

As described, if a carbon nanotube structure layer has the cross-linked site with a mainly identical cross-linking structure
where carbon nanotubes cross-link, a uniform network of the carbon nanotubes can be formed in a desired state. In addition, the carbon nanotube network can be constructed with homogeneous, satisfactory, and expected electrical or physical characteristics and high duplicability.

Further, the connecting group preferably employs a hydrocarbon as its skeleton. "Hydrocarbon as its skeleton" here refers to a main chain portion of the connecting group consisting of hydrocarbon, the main portion of the connecting group contributing to connecting residues together of the functional groups of carbon nanotubes to be cross-linked remaining after a cross-linking reaction. A side chain portion, where hydrogen of the main chain portion is substituted by another substituent, is not considered. Obviously, it is more preferable that the whole connecting group consist of hydrocarbon.

The number of carbon atoms in the hydrocarbon is preferably 2 to 10, more preferably 2 to 5, and further more preferably 2 or 3. The connecting group is not particularly limited as long as the connecting group is divalent or more.

In the cross-linking reaction of the functional group -COOR (where R represents a substituted or unsubstituted hydrocarbon) and ethylene glycol, exemplified as a preferable combination of the functional group of carbon nanotubes and the cross-linking agent, the cross-linked site where the carbon nanotubes mutually cross-link becomes -COO(CH₂)₂OCO-.

Further, in the cross-linking reaction of the functional group -COOR (where R represents a substituted or unsubstituted hydrocarbon) and glycerin, the cross-linked site where the carbon nanotubes mutually cross-link becomes -COOCH₂CHOHCH₂OCO- or -COOCH₂CH(OCO-)CH₂OH if two OH groups contribute in the cross-link, and the cross-linked site becomes -COOCH₂CH(OCO-)CH₂OCO- if three OH groups contribute in the cross-link.

In the transporting layer constituted by a carbon nanotube structure formed according to the second approach, functional groups are allowed to react with each other to form a cross-linked site. Therefore, an actual density of the carbon nanotubes in the carbon nanotube structure can be enhanced. Further, reducing a size of the functional group can extremely narrow a gap between the carbon nanotubes both electrically and physically, so characteristics of a single carbon nanotube can be easily exploited. Since a cross-linked site in the nanotube structure layer in which carbon nanotubes mutually Cross-link is formed by chemical bonding of functional groups, the structure is mainly an identical cross-linking structure. "Mainly identical" here is a concept including a case with all of the cross-linked sites having an identical cross-linking structure as well as a case with the cross-linking structure formed by chemical bonding of the functional groups becomes a main structure with respect to the whole cross-linked site.

As described above, a transporting layer having uniform electrical characteristics can be obtained as long as cross-linked sites in each of which carbon nanotubes mutually cross-link are mainly an identical carbon nanotube structure.

As described above, the electronic device of the present invention has a carbon nanotube structure in a state where a plurality of carbon nanotubes form a network structure via a plurality of cross-linked site each formed by chemical bonding. Therefore, the contact state and arrangement state of carbon nanotubes do not become unstable unlike a mere carbon nanotube dispersion film, so electron- and hole-transmission characteristics can be stably exerted. In addition, as described later, the degree of freedom in patterning of the carbon nanotube structure layer is high, so the transporting layer can have various shapes.

The electronic device of the present invention may have a layer other than the carbon nanotube structure layer to be used as a transporting layer and three or more electrodes. For example, it is preferable to interpose an adhesive layer between the surface of the base body and the carbon nanotube structure layer for enhancing adhesiveness between them because the adhesive strength of a patterned carbon nanotube structure layer can be enhanced. A method of forming an adhesive layer and other details will be described in the section titled [Method of Manufacturing an Electronic Device] .

Furthermore, a protective layer or any one of other various functional layers can be placed as an upper layer on the transporting layer of the patterned carbon nanotube structure. When the protective layer is placed as the upper layer of the transporting layer, the carbon nanotube structure layer as a network of cross-linked carbon nanotubes can be more strongly held on the surface of the base body, and can be protected from an external force. A resist layer to be described in the section titled [Method of Manufacturing an Electronic Device] can be used without removal as the protective layer. Of course, newly providing a protective layer for covering the entire surface including a region having a pattern other than a pattern corresponding to the transporting layer is effective. Any one of conventionally known various resin materials and inorganic materials can be used as a material constituting such a protective layer without any problem depending on purposes.

Furthermore, an integrated circuit can be constituted by forming multiple electronic devices on the same substrate. In particular, electronic devices using carbon nanotube structures as transporting layers can be easily integrated by combining: the formation of a carbon nanotube structure layer through application of a solution; and the patterning.

Alternatively, a highly integrated device can be prepared by:
laminating a transporting layer through the intermediation of an insulating layer; and appropriately connecting carbon nanotube structures between the layers. The connection between the layers may be performed by separately placing a carbon nanotube structure layer, by using another carbon nanotube, which itself is used as a wiring, or by wiring according to other methods such as the use of a metal film.

In addition, as described above, the base body can be a substrate having plasticity or flexibility. Using a substrate having plasticity or flexibility as the base body increases the number of applications. In particular, the carbon nanotube structure to be used in the present invention has a cross-linked site formed by chemical bonding. Therefore, flexibility which a carbon nanotube itself has is effectively exerted, and thus stabiliy against deformation is extremely high even if a device is constituted by using an electronic device using a substrate having plasticity or flexibility. Thus, it becomes possible to deal with various arrangements, shapes, and usages in a device.

A specific shape and the like of the electronic device of the present invention described above will be apparent in the section titled [Method of Manufacturing an Electronic Device] and the section titled Examples. Of course, the structures to be described later are merely illustrations, and specific modes of the electronic device of the present invention are not limited to these.

### [Method of Manufacturing an Electronic Device]

The method of manufacturing an electronic device of the present invention is a method suitable for manufacturing the electronic device of the present invention described above. Specifically, the method includes: (A) a step of applying a solution containing a plurality of carbon nanotubes having functional groups (cross-linking application solution) to the surface of a base body; (B) a step of mutually cross-linking the carbon nanotubes to construct a network structure through curing of the cross-linking application solution after the application to thereby form a carbon nanotube structure having the network structure; and, in accordance with the structure of an electronic device to be manufactured, a step of forming an electrode before or after the steps (A) and (B).

Furthermore, as required, the method may include another step such as (C) a step of patterning the carbon nanotube structure into a pattern corresponding to the transporting layer.

Hereinafter, the respective steps of a method of manufacturing a MOS-FET carbon nanotube transistor, which is an embodiment of the present invention, will be described with reference to the schematic sectional diagrams of Figs. 4.
(1) and (2) Gate electrode forming step
   A substrate 11 the surface of which has been cleansed is prepared and placed in a deposition apparatus . Then, a metal electrode serving as a gate electrode 14 is deposited. As described above, the substrate and the electrode material can be appropriately selected by taking resistance to subsequent etching or to a subsequent heating process into consideration.
(3) Gate insulating film forming step
   In a MOS-FET, a gate insulating film 13 must be formed between the gate electrode 14 and a transporting layer 10. In the case where an inorganic semiconductor material such as silicon is used as a transporting layer, a silicon oxide film or a silicon nitride film that tends to form a good interface with silicon is used as the gate insulating film in order to prevent an increase in interface state density involved in the surface oxidation of a semiconductor crystal. Even in the case where a carbon nanotube structure is used as a transporting layer, an existing insulating film that can utilize an existing semiconductor process such as a silicon oxide film, a silicon nitride film, aluminum oxide, or titanium oxide can be used.
   Although the method of forming the gate insulating film 13 depends on a material for the film, any one of methods such as application and firing of a MOD (Metal Organic Decomposition) material or deposition can be used.
(4) Supplying step
   In the present invention, the "supplying step" is a step of supplying the surface of the base body 11 with a solution 100 (cross-linking application solution) containing the carbon nanotubes having functional groups and a cross-linking agent which prompts a cross-linking reaction with the functional groups. A region with which the cross-linking application solution 100 is to be supplied has only to include the desired region, and it is not necessary to supply the entire surface of the base body 11 with the liquid.
   The supplying method, which is preferably application of a cross-linking solution, is not particularly limited, and any method can be adopted from a wide range. For example, the liquid may be simply dropped or spread with a squeegee or may be applied by a common application method. Examples of common application methods include spin coating, wire bar coating, cast coating, roll coating, brush coating, dip coating, spray coating, and curtain coating. The contents of the base body, the carbon nanotubes having functional groups, the cross-linking agent, and the cross-linking application solution are as described in the section titled [Electronic Device].
(5) Cross-linking step
   In the present invention, the "cross-linking step" is a step of mutually cross-linking the carbon nanotubes to construct a network structure through curing of the cross-linking application solution 100 after the application to thereby form a carbon nanotube structure 101. A region where the carbon nanotube structure 101 is to be formed by curing the cross-linking application solution in the cross-linking step has only to include the desired region, and it is not necessary to cure the entirety of the cross-linking application solution 100 applied to the surface of the base body.
   An operation carried out in the cross-linking step is automatically determined according to the combination of the functional groups with the cross-linking agent as shown in, for example, Table 1 above. If a combination of thermally curable functional groups is employed, the applied solution is heated by various heaters or the like. If a combination of functional groups that are cured by ultraviolet rays is employed, the applied solution is irradiated with a UV lamp or left under the sun. If a combination of self-curable functional groups is employed, it is sufficient to let the applied solution stand still. "Leaving the applied solution to stand still" is deemed as one of the operations that may be carried out in the cross-linking step of the present invention.
   For example, heat curing (polyesterification through an ester exchange reaction) is conducted for the case of a combination of a carbon nanotube, to which the functional group -COOR (where R represents a substituted or unsubstituted hydrocarbon group) is added, and a polyol (among them, glycerin and/or ethylene glycol) . Heating causes an ester exchange reaction between -COOR of the esterified carbon nanotube carboxylic acid and R'-OH (where R' represents a substituted or unsubstituted hydrocarbon group) of a polyol. As the reaction progresses multilaterally, the carbon nanotubes are cross-linked until a network of carbon nanotubes connected to each other constructs a carbon nanotube structure layer 14.
   To give an example of conditions preferable for the above combination, the heating temperature is specifically set to preferably 50 to 500°C, more preferably 150 to 200°C, and the heating period is specifically set to preferably 1 minute to 10 hours, more preferably 1 hour to 2 hours.
(6) Patterning step
   In the present invention, the "patterning step" is a step of patterning the carbon nanotube structure layer into a pattern corresponding to a transporting layer. Figs. 5(6) to (9) show schematic sectional diagrams showing (6) Patterning step.
   Although no particular limitations are put on operations of the patterning step, there are two preferred modes of (6-A) and (6-B) to the patterning step.

### (6-A)

A mode in which dry etching is performed on the carbon nanotube structure layer 101 in a region of the surface of the base body 11 other than the region having the pattern corresponding to the transporting layer, thus removing the carbon nanotube structure layer 101 from the region and patterning the carbon nanotube structure layer 101 into the pattern corresponding to the transporting layer 10.

Patterning the carbon nanotube structure layer into a pattern corresponding to the transporting layer 10 by dry etching means that the carbon nanotube structure layer 101 in a region of the surface of the base body other than the region having the pattern receives irradiation of radicals or the like. Methods of irradiation with radicals or the like include one in which the carbon nanotube structure layer 101 in a region other than a region having the pattern is directly irradiated with radicals or the like (6-A-1), and one in which the region other than a region having the pattern is covered with a resist layer 17 and then the entire surface of the base body (of course, on the side where the carbon nanotube structure layer and the resist layer are formed) is irradiated with radicals or the like (6-A-2).

### (6-A-1)

Direct irradiation of the carbon nanotube structure layer 101 in a region other than a region having the pattern with radicals or the like specifically means that the carbon nanotube structure layer 101 in a region of the surface of the base body other than the region having the pattern corresponding to the transporting layer 10 is irradiated with an ion of a gas molecule in the form of an ion beam, thereby removing the carbon nanotube structure layer 101 from the irradiated region and patterning the carbon nanotube structure layer 101 into a pattern corresponding to the transporting layer 10.

In the form of an ion beam, an ion of a gas molecule can be radiated selectively with precision on the order of several nm. This method is preferable in that the carbon nanotube structure layer can be patterned into a pattern corresponding to a transporting layer in one operation.

Examples of gas species that can be chosen for the ion beam method include oxygen, argon, nitrogen, carbon dioxide, and sulfur hexafluoride. Oxygen is particularly desirable in the present invention.

In the ion beam method, a voltage is applied to gas molecules in a vacuum to accelerate and ionize the gas molecules and the obtained ions are radiated in the form of a beam. The ion beam method is capable of etching various substances with varying irradiation accuracy by changing the type of gas used.

### (6-A-2)

In the mode in which the regions other than the region having the pattern are covered with a resist layer 17 before the entire surface of the base body is irradiated with radicals or the like, the patterning step includes:
a resist layer forming step (6-A-2-1) of forming a resist layer 17 above the carbon nanotube structure layer 101 in a region on the surface of the base body having the pattern corresponding to the transporting layer; and
a removing step (6-A-2-2) of removing the carbon nanotube structure layer 101 exposed in a region other than the region by subjecting a surface of the base body on which the carbon nanotube structure layer 101 and the resist layer 17 are laminated to dry etching. The patterning step may include:
   a resist layer peeling-off step (6-A-2-3) of peeling off the resist layer 17 formed in the resist layer forming step subsequent to the removing step.

### (6-A-2-1) Resist layer forming step

In the resist layer forming step, the resist layer 17 is formed above the carbon nanotube structure layer 101 in a region on the surface of the base body having the pattern corresponding to the transporting layer 10. This step follows a process generally called a photolithography process and, instead of directly forming a resist layer above the carbon nanotube structure layer in a region having the pattern corresponding to the transporting layer, the resist layer 17 is once formed on the entire surface of the base body 11 on the side where the carbon nanotube structure layer 101 is formed as shown in Fig. 5(6). Then, the region having the pattern corresponding to the transporting layer is exposed to light and portions that are not exposed to light are removed through subsequent development. Ultimately, the resist layer 17 is present on the carbon nanotube structure layer 101 in the region having the pattern corresponding to the transporting layer.

Fig. 5(7) is a schematic sectional diagram showing a state of the surface of the base body after (C-A-2-1) resist layer forming step. Depending on the type of resist, a portion that is exposed to light is removed by development while a portion that is not exposed to light remains.

A known method can be employed to form the resist layer. Specifically, the resist layer 17 is formed by applying a resist agent to the substrate with a spin coater or the like and then heating the applied agent.

There is no particular limitation on the material (resist agent) used to form the resist layer 17, and various known resist materials can be employed without any modification. Employing resin (forming a resin layer) is particularly desirable. The carbon nanotube structure layer 101 has a mesh-like network of carbon nanotubes and is a porous structure. Accordingly, if the resist layer 17 is formed fromametal evaporation film or like othermaterial that forms a film on the very surface and does not infiltrate deep into the holes of the mesh, carbon nanotubes cannot be sealed satisfactorily against radiation of plasma or the like (insufficient sealing means exposure to plasma or the like). As a result, plasma or the like enters from the holes and corrodes the carbon nanotube layer under the resist layer 17, reducing the contour of the remaining carbon nanotube structure layer due to diffraction of plasma or the like. Although it is possible to give the resist layer 17 a larger contour (area) than the pattern corresponding to the transporting layer, taking into account this reduction in size, this method requires a wide gap between patterns and therefore makes it impossible to form patterns close together.

In contrast, when resin is used to form the resist layer 17, the resin enters the spaces inside the holes and reduces the number of carbon nanotubes that are exposed to plasma or the like. As a result, high density patterning of the carbon nanotube structure layer 101 can be performed.

Examples of the resin material that mainly constitutes the resin layer include, but not limited thereto, novolac resin, polymethyl methacrylate, and a mixture of the two.

The resist material for forming the resist layer 17 is a mixture of one of the above resin materials, or a precursor thereof, and a photosensitive material or the like. The present invention can employ any known resist material. For instance, OFPR 800, a product of TOKYO OHKA KOGYO CO., LTD. and NPR 9710, a product of NAGASE & CO., LTD. can be employed.

Appropriate operations or conditions to expose the resist layer 17 before curing to light (heating if the resist material used is thermally curable, a different exposure method is chosen for a different type of resist material) and to develop are selected in accordance with the resist material used. (Examples of exposure and development operations or conditions include the light source wavelength, the intensity of exposure light, the exposure time, the exposure amount, environmental conditions during exposure, the development method, the type and concentration of developer, the development time, and what pre-treatment or post-treatment is to be employed.) When a commercially available resist material is used, the instructionmanual for the product should be followed. In general, for conveniences of handling, the layer is exposed to ultraviolet rays to draw the pattern corresponding to the transporting layer. After that, the film is developed using an alkaline developer, which is then washed off with water, and is let dry to complete the photolithography process.

### (6-A-2-2) Removing Step

In the removing step, dry etching is performed on a surface of the base body on which the carbon nanotube structure layer 101 and the resist layer 17 are laminated, thereby removing the carbon nanotube structure layer exposed in a region other than the region. (See Fig. 5(7). The carbon nanotube structure layer 101 is exposed in a region from which the resist layer 17 is removed). Fig. 5(8) is a schematic sectional diagram showing a state of the surface of the base body after (6-A-2-2) removing step.

The removing step can employ every method that is generally called dry etching, including the reactive ion method. The above-described ion beam method in (6-A-1) is one of the dry etching methods.

See the section (6-A-1) for employable gas species, devices, operation environments, and the like.

In the present invention, oxygen is particularly desirable out of examples of gas species generally usable in dry etching which include oxygen, argon, and fluorine-based gas (e.g., chlorofluoro carbon, SF₆, and CF₄). With oxygen radicals, carbon nanotubes in the carbon nanotube structure layer 14 to be removed are oxidized (burnt) and turned into carbon dioxide. Accordingly, the residue has little adverse effect, and accurate patterning is achieved.

When oxygen is chosen as gas species, oxygen radicals are generated by irradiating oxygen molecules with ultraviolet rays, and used. A device that generates oxygen radicals by means of this method is commercially available by the name of UV usher, and is easy to obtain.

### (6-A-2-3) Resist layer peeling-off step

The method of manufacturing an electronic device of the present invention may shift to (7) Step of forming source and drain electrodes after the completion of (6-A-2-2) removing step. If the resist layer 17 is to be removed, the removing step has to be followed by a resist layer peeling-off step of peeling off the resist layer 17 formed in the resist layer forming step. Fig. 5 (9) is a schematic sectional diagram showing a state of the surface of the base body after (6-A-2-3) resist layer peeling-off step.

An appropriate resist layer peeling-off step operation is chosen in accordance with the material used to form the resist layer 17. When a commercially available resist material is used, the resist layer 17 is peeled off following the instruction manual for the product. When the resist layer 17 is a resin layer, a common removal method is to bring the resin layer into contact with an organic solvent that is capable of dissolving the resin layer.

### (6-B)

A mode in which the patterning step includes:
a resist layer forming step of forming a resist layer above the carbon nanotube structure layer in a region on the surface of the base body having the pattern corresponding to the transporting layer; and
a removing step of removing the carbon nanotube structure layer exposed in a region other than the region by bringing a surface of the base body on which the carbon nanotube structure layer and the resist layer are laminated into contact with an etchant.

The mode is a method commonly called wet etching (a method of removing an arbitrary portion using chemical = etchant).

The resist layer forming step in Mode (C-B) is identical with (6-A-2-1) resist layer forming step described above except that a resist material having resistance to the etchant should be used in Mode (C-B). Similar to Mode (C-A) patterning step, the removing step in Mode (C-B) patterning step may be followed by the resist layer peeling-off step and details of this peeling-off step are as described in (6-A-2-3) resist layer peeling-off step. Detailed descriptions of these steps are therefore omitted here.

Reference is made to Fig. 5(7). In the removing step, an etchant is brought into contact with the surface of the base body 11 on which the carbon nanotube structure layer 101 and the resist layer 17 are laminated, thereby removing the carbon nanotube structure layer 101 exposed in a region other than the region.

In the present invention, "bringing an etchant into contact with" is a concept including all operations for bringing a liquid into contact with a subject, and a liquid may be brought into contact with a subject by any methods such as dipping, spraying, and letting a liquid flow over a subject.

The etchant is in general an acid or alkali. Which etchant to choose is determined by the resist material constituting the resist layer 17, the cross-linking structure among carbon nanotubes in the carbon nanotube structure layer 101, and other factors. A desirable etchant is one that etches the resist layer 17 as little as possible and that can easily remove the carbon nanotube structure layer 101.

However, an etchant that etches the resist layer 17 may be employed if it is possible to, by appropriately controlling the temperature and concentration of the etchant and how long the etchant is in contact with the carbon nanotube structure layer, remove the exposed carbon nanotube structure layer 101 before the resist layer 17 is completely etched away.

### (7) Step of forming source and drain electrodes

In the same manner as in the (2) gate electrode forming step, a source electrode 15 and a drain electrode 16 are arranged on the remaining carbon nanotube structure layer 101, which functions as the transporting layer 10, so as to be opposed to each other with a gap between the electrodes. Fig. 5(10) shows a schematic sectional diagram showing a state of the surface of the base body after the step. Materials for the electrodes are identical with the case of the gate electrode, and are preferably selected by taking wettability with respect to the gate insulating film/the carbon nanotube structure layer into consideration.

As described above, in the case of a bottom gate, a gate electrode is formed first as in the description of this embodiment. In contrast, in the case of a top gate, the step of forming source and drain electrodes is performed first.

### (8) Other steps

The electronic device of the present invention can be manufactured through the above steps. However, the method of manufacturing an electronic device of the present invention may include additional steps.

For instance, it is preferable to put a surface treatment step for pre-treatment of the surface of the base body before the applying step. The purpose of the surface treatment step is, for example, to enhance the absorption of the cross-linking application solution to be applied, to enhance the adhesion between the surface of the base body and the carbon nanotube structure layer to be formed thereon as an upper layer, to clean the surface of the base body, or to adjust the electric conductivity of the surface of the base body.

An example of surface treatment for enhancing the absorption of the cross-linking application solution is treatment by a silane coupling agent (e.g., aminopropyltriethoxysilane or γ-(2-aminoethyl)aminopropyltrimethoxysilane). Surface treatment by aminopropyltriethoxysilane is particularly widely employed and is preferable for the surface treatment step in the present invention. As documented by Y. L. Lyubchenko et al. in "Nucleic Acids Research vol. 21 (1993) " on pages 1117 to 1123, for example, surface treatment by aminopropyltriethoxysilane has conventionally been employed to treat the surface of a mica substrate for use in observation of AFM of DNA.

In the case where two or more carbon nanotube structure layers are to be laminated, the operation of the method of manufacturing an electronic device of the present invention is repeated twice or more. If an intermediate layer such as a dielectric layer or an insulating layer is to be interposed between carbon nanotube structure layers, a step for forming the layer is inserted in between and then the operation of the method of manufacturing an electronic device of the present invention is repeated.

In the case where a plurality of electronic devices of the present invention are juxtaposed and integrated on a substrate, the plurality of electronic devices are produced in tandem in the respective patterning steps and interconnection is established between a device and another device or an element such as a resistor or a capacitor to form a circuit.

In addition, in the case where other layers such as a protective layer and an electrode layer are separately laminated, a step for forming these layers is needed. Each of those layers may be appropriately formed by selecting the material and forming method for the layer depending on a purpose from conventionally known ones or by using a product or method newly developed for the present invention.

### <Applied Example of Method of Manufacturing an Electronic Device of the Present Invention>

An applied example of the method of manufacturing an electronic device of the present invention is, for example, a method involving the steps of: patterning a carbon nanotube structure layer on the surface of a temporary substrate; and transferring the patterned carbon nanotube structure layer onto a desired base body. In addition, in the transferring step, the patterned carbon nanotube structure layer may be transferred from the temporary substrate to the surface of an intermediate transfer body and then to a desired base body (second base body).

A specific method of forming a MES-FET carbon nanotube transistor, which is an embodiment of the present invention, will be described with reference to Figs. 15.

In the same manner as that described above, a carbon nanotube structure is formed on a temporary substrate 11', and is patterned into a shape corresponding to the transporting layer 10 (Fig. 15 (a)). In this explanation, two transporting layers were simultaneously formed on the temporary substrate.

Subsequently, a substrate 11 on which an adhesive surface 111 has been formed is attached to the transporting layer 10 on the temporary substrate 11' (Figs. 15(b) and (c)).

The substrate 11 and the temporary substrate 11' are peeled off of each other, whereby the transporting layer 10 is transferred onto the substrate 11 (Fig. 15(d)).

Subsequently, the gate electrode 14, the source electrode 15, and the drain electrode 16 are formed by means of sputtering or the like on the transporting layer 10 transferred onto the substrate 11.

Thus, two top gate MES-FET's are simultaneously formed (Fig. 15 (e)).

The temporary substrate material that can be used in this applied example is preferably the same as the base body material described in the section titled [Electronic Device]. However, a temporary substrate that has at least one flat surface, more desirably, one that is shaped like a flat plate is preferable in consideration of transfer suitability in the transferring step.

To be employable in the applied example, a base body or an intermediate transfer body has to have an adhesive surface holding, or capable of holding, an adhesive. Common tape such as cellophane tape, paper tape, cloth tape, or imide tape can be of course used in the applied example. In addition to the tape and other materials that have plasticity or flexibility, rigid materials may also be employed as a base body or an intermediate transfer body. In the case of a material that does not come with an adhesive, an adhesive is applied to a surface of the material that can hold an adhesive, and then the material can be used in a similar fashion to normal adhesive tape.

According to the applied example, the electronic device of the present invention can be easily manufactured.

An electronic device can also be manufactured by: preparing a base body in a state where a carbon nanotube structure layer is carried on the surface of the base body; and attaching the base body to a surface of a desired second base body (for example, a casing) on which 3 electrodes for constituting the electronic device have been formed.

Alternatively, even when the user skips the cross-linking step, a transporting layer of an electronic device can be also manufactured by: using a carbon nanotube transfer body in which a carbon nanotube structure layer is carried on the surface of a temporary substrate (or intermediate transfer body) to transfer only the carbon nanotube structure layer onto the surface of a base body constituting the electronic device; and removing the temporary substrate (or intermediate transfer body). Here, the intermediate transfer body may serve as a temporary substrate of the carbon nanotube transfer body during the process. However, there is no need to distinguish the intermediate transfer body from the carbon nanotube transfer body itself, and hence the case is also included in the present invention. The electronic device can be formed by forming the 3 electrodes on the substrate in advance or by forming them after the removal of the temporary substrate.

The use of a carbon nanotube transfer body extremely simplifies the subsequent handling because a carbon nanotube structure layer in a cross-linked state is carried on the surface of a temporary substrate. Therefore, the manufacture of an electronic device can be performed with extreme ease. A method of removing a temporary substrate can be appropriately selected from simple peeling, chemical decomposition, burnout, melting, sublimation, dissolution, and the like.

The applied example of the method of manufacturing an electronic device is particularly effective in the case where a base body of a device has a material and/or shape that make it difficult to apply the method of manufacturing an electronic device of the present invention without some changes.

For instance, the applied example of the present invention is effective in the case where the temperature at which the solution after the application is cured in the cross-linking step is equal to or higher than the melting point or glass transition point of the material that is to be used as a base body of the device. In this case, the heating temperature is set lower than the melting point of the temporary substrate to ensure a heating temperature necessary for the curing, and thus the electronic device of the present invention can be manufactured appropriately.

To give another example, the applied example of the present invention is effective also when the patterning step takes a mode in which dry etching is performed on the carbon nanotube structure in a region of the surface of the temporary substrate other than the region having the pattern corresponding to the transporting layer, thus removing the carbon nanotube structure layer in the region and patterning the carbon nanotube structure into a pattern corresponding to the transporting layer while the material that is to be used as a base body of the electronic device has no resistance to dry etching of the patterning step. In this case, a material having resistance to dry etching is used as the temporary substrate so that the resistance to the operation of the step of patterning on the temporary substrate can be ensured, and thus the electronic device of the present invention can be manufactured appropriately.

Although specifics on resistance, material, and the like vary depending on dry etching conditions including gas species, intensity, time, temperature, and pressure, resin materials have relatively low resistance to dry etching. When a resin material is used as the base body, limitations brought by low resistance of the resin material are lifted by employing this applied example. Therefore, forming the base body from a resin material is preferable in that merits of the applied example are brought out. On the other hand, inorganic materials which have relatively high resistance to dry etching are suitable for the temporary substrate. In general, plastic or flexible materials have low resistance to dry etching and therefore using one of such materials as the base body is preferable in that merits of this applied example are brought out.

To give another example, the applied example of the present invention is effective also in the case where the patterning step includes: a resist layer forming step of forming a resist layer above the carbon nanotube structure layer in a region on the surface of the temporary substrate having the pattern corresponding to the transporting layer; and a removing step of removing the carbon nanotube structure layer exposed in a region other than the region by bringing a surface of the temporary substrate on which the carbon nanotube structure layer and the resist layer are laminated into contact with an etchant, and the base body has no resistance to the etchant used in the patterning step, but the temporary substrate has resistance to the etchant. In this case, a base body of the electronic device serves as the base body in this applied example and a material having resistance to the etchant is used as the temporary substrate, so the resistance to the operation of the step of patterning onto the temporary substrate can be ensured. Thus, the electronic device of the present invention can be manufactured appropriately.

Specifics on resistance and material vary depending on etching conditions including the type, concentration, and temperature of the etchant used, how long the etchant is in contact with the carbon nanotube structure layer, and the like. When an acidic etchant is used and a base body of the electronic device is to be formed from aluminum or like other materials that do not withstand acid, for example, limitations brought by low resistance of the base body material are lifted by employing the applied example and using silicon or other materials having resistance to acid as the temporary substrate. Limitations brought by low resistance are also lifted by using as the base body a material that has low resistance to an etchant as described above although depending on whether the etchant is acidic or alkaline.

As another mode, for making the electronic device of the present invention easy to handle even more, a base body that carries the carbon nanotube structure may be pasted onto a second base body to constitute the electronic device of the present invention or an apparatus using the same. The second base body may be physically rigid or may be plastic or flexible, and can take various shapes including a spherical shape and a concave-convex shape.

### <More Specific Example>

A more specific description of the present invention is given below through Examples. However, the present invention is not limited to the following examples.

### [Example 1]

A MOS-FET carbon nanotube transistor was manufactured through a flow of the method of manufacturing an electronic device shown in Figs. 4 and 5. It should be noted that reference numerals in Figs. 4 and 5 may be used in the description of this example.
(A) Applying step (A-1) Preparation of cross-linking application solution (adding step)
   (i) Purification of single-wall carbon nanotube
      Single-wall carbon nanotube powder (purity 40%, manufactured by Sigma-Aldrich Co.) was sifted through a sieve (125 µm in pore size) in advance to remove a coarse agglomerate. 30 mg of the remainder (having an average diameter of 1. 5 nm and an average length of 2 µm) were heated at 450 °C for 15 minutes by using a muffle furnace, and then a carbon substance other than a carbon nanotube was removed. 15 mg of the remaining powder were immersed in 10 ml of a 5-N aqueous solution of hydrochloric acid {prepared by diluting concentrated hydrochloric acid (a 35% aqueous solution, manufactured by KANTO KAGAKU) with pure water by a factor of 2} to dissolve a catalyst metal.
      The solution was filtered to collect a precipitate. The collected precipitate was subjected to the heating step 3 times and the step of immersing in hydrochloric acid 3 times for purification. At that time, conditions for heating were gradually made more severe: 450°C for 20 minutes, then 450°C for 30 minutes, and then 550°C for 60 minutes.
      The carbon nanotube after the purification is found to show a remarkable increase in purity as compared to that before the purification (raw material) (more specifically, the purity is estimated to be 90% or higher). The finally obtained purified carbon nanotube had a mass (1 to 2 mg) of about 5% of the mass of the raw materials.
      The above operation was repeated a number of times to purify 15 mg or more of high-purity single-wall carbon nanotube powder.
   (ii) Addition of carboxyl group ... Synthesis of carbon nanotube carboxylic acid
      30 mg of multi-wall carbon nanotube powder (purity: 90%, average diameter: 30 nm, average length: 3 µm, manufactured by Science Laboratory Inc.) were added to 20 ml of concentrated nitric acid (a 60 mass% aqueous solution, manufactured by KANTO KAGAKU) for reflux at 120°C for 5 hours to synthesize a carbon nanotube carboxylic acid. A reaction scheme of the above is shown in Fig. 6. In Fig. 6, a carbon nanotube (CNT) is represented by two parallel lines (same applies for other figures relating to reaction schemes).
      The temperature of the solution was returned to room temperature and the solution was subjected to centrifugal separation at 5,000 rpm for 15 minutes to separate supernatant liquid from precipitate. The recovered precipitate was dispersed in 10 ml of pure water, and the dispersion liquid was subjected to centrifugal separation again at 5, 000 rpm for 15 minutes to separate supernatant liquid from precipitate (the above process constitutes one washing operation). This washing operation was repeated five more times and lastly precipitate was recovered.
      An infrared absorption spectrum of the recovered precipitate wasmeasured. An infrared absorption spectrum of the usedmulti-wall carbon nanotube raw material itself was also measured for comparison. A comparison between both the spectra revealed that absorption at 1, 735 cm⁻¹ characteristic of a carboxylic acid, which was not observed in the single-wall carbon nanotube raw material itself, was observed in the precipitate. This finding shows that a carboxyl group was introduced into a carbon nanotube by the reaction with nitric acid. In other words, this finding confirmed that the precipitate was a carbon nanotube carboxylic acid.
      Addition of the recovered precipitate to neutral pure water confirmed that dispersability was good. This result supports the result of the infrared absorption spectrum that a hydrophilic carboxyl group was introduced into a carbon nanotube.
   (iii) Esterification

   30 mg of the carbon nanotube carboxylic acid prepared in the above step were added to 25 ml of methanol (manufactured by Wako Pure Chemical Industries, Ltd.). Then, 5ml of concentrated sulfuric acid (98 mass%, manufactured by Wako Pure Chemical Industries, Ltd.) were added to the mixture, and reflux was conducted at 65°C for 6 hours for methyl esterification. The reaction scheme for the above-mentioned methyl esterification is shown in Fig. 7.
   After the temperature of the solution had been recovered to room temperature, the solution was filtered to separate a precipitate. The precipitate was washed with water, and was then recovered. An infrared absorption spectrum of the recovered precipitate was measured. As a result, absorption at 1,735 cm⁻¹ and that in the range of 1,000 to 1,300 cm⁻¹ characteristic of ester were observed. This result confirmed that the carbon nanotube carboxylic acid was esterified.

### (Mixing step)

30 mg of the carbon nanotube carboxylic acid methyl esterified in the above step were added to 4 g of glycerin (manufactured by KANTO KAGAKU) and the whole was mixed using an ultrasonic disperser. Further, the mixture was added to 4 g of methanol as a viscosity adjuster to prepare a cross-linking application solution (100).

### (A-2) Surface treatment step of base body

Prepared was a silicon wafer having a silicon oxide film on its surface for insulation (manufactured by Advantech Co., Ltd, 76.2 mmΦ (diameter of 3 inches), thickness of 380 µm, thickness of a surface oxide film of 1 µm) as the base body 11. An aluminum thin film was deposited as the gate electrode 14 on the wafer. The silicon oxide insulating film 13 was formed on the gate electrode 14 by using a MOD coating material of silicon oxide (manufactured by JAPAN PURE CHEMICAL CO., LTD.). The width of the gate electrode was set to 2,000 µm.

The silicon wafer was subjected to surface treatment using aminopropyltriethoxysilane for enhancing adsorption of the silicon wafer with respect to the cross-linking application solution (100) to be applied to the wafer.

The silicon wafer was subjected to the surface treatment using aminopropyltriethoxysilane by exposing the silicon wafer to steam of 50 µl of aminopropyltriethoxysilane (manufactured by Sigma-Aldrich Co.) for about 3 hours in a closed Schale.

For comparison, a silicon wafer which had not been subjected to surface treatment was also separately prepared.

### (A-3) Applying step

The cross-linking application solution 100 (1 µl) prepared in Step (A-1) was applied to the surface of the silicon wafer subjected to the surface treatment by using a spin coater (1H-DX2, manufactured by MIKASA Co., Ltd.) at 100 rpm for 30 seconds. The solution was similarly applied to the silicon wafer for comparison which had not been subjected to the surface treatment.

### (B) Cross-linking step

After the application of the cross-linking application solution 100, the silicon wafer (base body 11) on which the applied film had been formed was heated at 200°C for 2 hours to cure the applied film, thereby forming the carbon nanotube structure layer 101 (Fig. 4(5)). Fig. 8 shows the reaction scheme.

The observation of the state of the obtained carbon nanotube structure layer 101 by means of an optical microscope confirmed an extremely uniform cured film.

### (C) Patterning step

### (C-1) Resist layer forming step

A resist agent 170 (manufactured by Nagese & Co. , LTD, NPR9710, viscosity of 50 mPa·s) was applied to the surface on the side of the carbon nanotube structure layer 101 of the silicon wafer 12 (subjected to surface treatment) on which the carbon nanotube structure layer 101 had been formed by using a spin coater (manufactured by Mikasa, 1H-DX2) at 2, 000 rpm for 20 seconds. Then, the applied agent was heated at 100°C for 2 minutes to form a film, thereby forming the resist layer 17 (Fig. 5(6)).

The resist agent NPR9710 had the following composition.
·Propylene glycol monomethyl ether acetate: 50 to 80 mass%
·Novolac resin: 20 to 50 mass%
·Photosensitive agent: less than 10 mass%

The surface on the side of the resist layer 17 of the silicon wafer 11 on which the carbon nanotube structure layer 101 and the resist layer 17 had been formed was exposed to light to have a shape corresponding to the transporting layer 10 to be used for a MOS-FET under the condition of a light amount of 12.7 mW/cm² for 8 seconds by using a mask aligner (mercury vapor lamp manufactured by Mikasa, MA-20, wavelength of 436 nm).

Furthermore, the exposed silicon wafer 11 was heated on a hot plate at 110°C for 1 minute. Then, the silicon wafer was left to stand to cool, and development was performed on a developing machine (AD-1200, Takizawa Industries) by using as a developer NMD-3 manufactured by TOKYO OHKA KOGYO CO., LTD. (tetramethyl ammonium hydroxide 2.38 mass%) (Fig. 5(7)). At this time, an optical microscope was used to confirm that the resist layer 17 was formed into a shape of the transporting layer 10.

### (C-2) Removing step

The silicon wafer 11 on which the resist layer 17 had been thus formed into the shape of the predetermined pattern was heated in a mixed gas (oxygen 10 mL/min, nitrogen 40 mL/min) at 200°C and irradiated with ultraviolet rays (172 nm) for 2 hours by using a UV usher (excimer vacuum ultraviolet lamp, manufactured by Atom Giken, EXM-2100BM, wavelength of 172 nm) to generate oxygen radicals, thereby removing a portion of the carbon nanotube structure layer 101 which was not protected by the resist layer 17. As a result, the carbon nanotube structure layer 101 was formed into the shape of the transporting layer 10 in a state of being covered with the resist layer 17 (Fig. 5(8)).

The resist layer 17 remains on the surface of the base body 11 through the carbon nanotube structure layer 101.

### (C-3) Resist layer peeling-off step

The resist layer 17 remaining as an upper layer of the carbon nanotube structure layer 10 formed into the shape of the "predetermined pattern" was removed by washing it with acetone (Fig. 5(9)) to obtain a transporting layer of an electronic device of Example 1.

Gold was deposited on the transporting layer as the source electrode 15 and the drain electrode 16 to obtain a MOS-FET carbon nanotube field effect transistor shown in Fig. 1 (Fig. 5 (10)). The gap between the source electrode 15 and the drain electrode was set to 1,000 µm.

Next, a semiconductor parameter analyzer 4156B (manufactured by Agilent Technologies) was used to measure direct current-voltage characteristics for a current between the source and drain electrodes with respect to a voltage Vgs of the gate electrode. Fig. 10 shows the result. The result confirmed that the carbon nanotube structure serves as the transporting layer because the conductivity between the drain and source electrodes changes with the gate voltage.

### [Example 2]

A MES-FET carbon nanotube field effect transistor shown in Fig. 3 was produced in the same manner as in Example 1 except that the insulating film forming step was omitted. At this time, the gate electrode width and the distance between the source and drain electrodes were set to 500 µm and 1,500 µm, respectively. Then, the field effect transistor was subjected to measurement by means of a parameter analyzer 4156B (manufactured by Agilent Technologies) in the same manner as in Example 1 to confirm a change in electric conductivity between the source and the drain with the gate voltage Vgs. The result confirmed that the current between the source and the drain can be controlled by the gate voltage (Fig. 11).

### [Example 3]

A carbon nanotube structure was formed by using a cross-linking application solution using a multi-wall carbon nanotube, and a MOS-FET carbon nanotube field effect transistor shown in Fig. 1 was produced in the same manner as in Example 1. A method of forming an applied film will be shown below. The other steps were the same as those of Example 1.
(A) Applying step
(A-1) Preparation of cross-linking application solution (Addition step)
   (i) Addition of carboxyl group ... Synthesis of carbon nanotube carboxylic acid

30 mg of multi-wall carbon nanotube powder (purity: 90%, average diameter: 30 nm, average length: 3 µm, manufactured by Science Laboratory Inc.) were added to 20 ml of concentrated nitric acid (a 60 mass% aqueous solution, manufactured by KANTO KAGAKU) for reflux at 120°C for 20 hours to synthesize a carbon nanotube carboxylic acid.

The temperature of the solution was returned to room temperature and the solution was subjected to centrifugal separation at 5,000 rpm for 15 minutes to separate supernatant liquid from precipitate. The recovered precipitate was dispersed in 10 ml of pure water, and the dispersion liquid was subjected to centrifugal separation again at 5, 000 rpm for 15 minutes to separate supernatant liquid from precipitate (the above process constitutes one washing operation). This washing operation was repeated five more times and lastly precipitate was recovered.

An infrared absorption spectrum of the recovered precipitate wasmeasured. An infrared absorption spectrum of the used multi-wall carbon nanotube raw material itself was also measured for comparison. A comparison between both the spectra revealed that absorption at 1,735 cm⁻¹ characteristic of a carboxylic acid, which was not observed in the multi-wall carbon nanotube raw material itself, was observed in the precipitate. This finding shows that a carboxyl group was introduced into a carbon nanotube by the reaction with nitric acid. In other words, this finding confirmed that the precipitate was a carbon nanotube carboxylic acid.

Addition of the recovered precipitate to neutral pure water confirmed that dispersability was good. This result supports the result of the infrared absorption spectrum that a hydrophilic carboxyl group was introduced into a carbon nanotube.

### (Mixing step)

5 mg of the carbon nanotube carboxylic acid obtained in the above step and 30 mg of 1, 4-hydroquinone (manufactured by Wako Pure Chemical Industries, Ltd.) were added to 20 ml of dimethylformamide (manufactured by Wako Pure Chemical Industries, Ltd.), and the whole was further mixed with N-ethyl-N'-(3-dimethylaminopropyl)carbodiimide (hydrochloride, manufactured by Sigma-Aldrich Co.) using an ultrasonic disperser.

30 mg of the carbon nanotube carboxylic acid methyl esterified in the above step were added to 4 g of glycerin (manufactured by KANTO KAGAKU), and the whole was mixed using an ultrasonic disperser. Further, the mixture was added to 4 g of methanol as a viscosity adjuster to prepare a cross-linking application solution (1). Fig. 9 shows the reaction scheme.

Next, a semiconductor parameter analyzer 4156B (manufactured by Agilent Technologies) was used to measure direct current-voltage characteristics for a current between the source and drain electrodes with respect to a voltage of the gate electrode (Fig. 12).

The result confirmed that the electric conductivity between the source and drain electrodes can be changed with the gate voltage Vgs, and that the carbon nanotube structure using a multi-wall carbon nanotube serves as the transporting layer.

### [Example 4]

A MES-FET electronic device shown in Fig. 3 was produced by using a carbon nanotube structure using a multi-wall carbon nanotube in the same manner as in Example 3 except that the insulating film forming step in Example 3 was omitted. Next, a semiconductor parameter analyzer 4156B (manufactured by Agilent Technologies) was used to measure direct current-voltage characteristics for a current between the source and drain electrodes with respect to a voltage of the gate electrode (Fig. 13).

The result confirmed that the carbon nanotube structure serves as the transporting layer because the conductivity between the drain and source electrodes changes with the gate voltage.

### [Example 5]

A carbon nanotube structure was formed by using a cross-linking application solution using a multi-wall carbon nanotube, and a MOS-FET semiconductor device shown in Fig. 1 was produced in the same manner as in Example 3. A mixing step for the cross-linking application solution different from Example 3 will be explained.

### (Mixing Step)

30 mg of the carbon nanotube carboxylic acid methyl esterified in the above step were added to 4 g of glycerin (manufactured by KANTO KAGAKU), and the whole was mixed using an ultrasonic disperser. Further, the mixture was added to 4 g of methanol as a viscosity adjuster to prepare a cross-linking application solution (1).

Next, a semiconductor parameter analyzer 4156B (manufactured by Agilent Technologies) was used to measure direct current-voltage characteristics for a current between the source and drain electrodes with respect to a voltage of the gate electrode. The result confirmed that the carbon nanotube structure can be used as the transporting layer because the conductivity between the drain and source electrodes changes with the gate voltage (Fig. 14).

## Claims

1. An electronic device, **characterized by** comprising:
three or more electrodes; and
a transporting layer constituted by a carbon nanotube structure formed into a network structure by a plurality of carbon nanotubes and cross-linked sites each constituted by chemical bonding of the different carbon nanotubes, in which a carrier is transported in accordance with a voltage applied to the electrodes.

2. An electronic device according to claim 1, **characterized in that** the electrodes comprise at least a source electrode, a drain electrode, and a gate electrode to constitute a field effect transistor structure.

3. An electronic device according to claim 2, **characterized in that** the field effect transistor structure comprises a MOS-FET structure.

4. An electronic device according to claim 2, **characterized in that** the field effect transistor structure comprises a MES-FET structure.

5. An electronic device according to any one of claims 1 to 4, **characterized in that**, in the carbon nanotube structure layer, the carbon nanotubes for connection between cross-linked sites of the carbon nanotubes comprise mainly single-wall carbon nanotubes.

6. An electronic device according to any one of claims 1 to 4, **characterized in that**, in the carbon nanotube structure layer, the carbon nanotubes for connection between cross-linked sites of the carbon nanotubes comprise mainly multi-wall carbon nanotubes.

7. An electronic device according to any one of claims 1 to 6, **characterized in that** chemical bonds constituting the cross-linked sites comprise at least one chemical bond selected from the group consisting of (-COO(CH₂)₂OCO-), -COOCH₂CHOHCH₂OCO-, -COOCH₂CH (OCO-) CH₂OH, -COOCH₂CH(OCO-)CH₂OCO-, and -COO-C₆H₄-COO-.

8. An electronic device according to any one of claims 1 to 7, **characterized in that** the chemical bonds constituting the cross-linked sites comprise at least one chemical bond selected from the group consisting of -COOCO-, -O-, -NHCO-, -COO-, -NCH-, -NH-, -S-, -O-, -NHCOO-, and -S-S-.

9. An electronic device according to claim 1, **characterized in that** the carbon nanotube structure is obtained by using a solution containing a plurality of carbon nanotubes to which functional groups are bonded and forming a cross-linked site through chemical bonding of the functional groups bonded to the carbon nanotubes.

10. An electronic device according to claim 9, **characterized in that** the carbon nanotube structure is obtained by curing a solution containing carbon nanotubes having functional groups and a cross-linking agent that prompts a cross-linking reaction with the functional groups, prompting a cross-linking reaction between each of the functional groups bonded to the different carbon nanotubes and the cross-linking agent, and forming a cross-linked site.

11. An electronic device according to claim 10, **characterized in that** the cross-linking agent comprises a non-self-polymerizable cross-linking agent.

12. An electronic device according to claim 10 or 11, **characterized in that** the functional groups comprise at least one group selected from the group consisting of -OH, -COOH, -COOR (where R represents a substituted or unsubstituted hydrocarbon group), -COX (where X represents a halogen atom), -NH₂, and -NCO, and the cross-linking agent comprises a cross-linking agent which may prompt a cross-linking reaction with the selected functional groups.

13. An electronic device according to any one of claims 10 to 12, **characterized in that** the cross-linking agent comprises at least one cross-linking agent selected from the group consisting of a polyol, a polyamine, a polycarboxylic acid, a polycarboxylate, a polycarboxylic acid halide, a polycarbodiimide, a polyisocyanate, and hydroquinone, and the functional groups comprise functional groups which may prompt a cross-linking reaction with the selected cross-linking agent.

14. An electronic device according to claim 10 or 11,
**characterized in that**:
the functional groups comprise at least one group selected from the group consisting of -OH, -COOH, -COOR (where R represents a substituted or unsubstituted hydrocarbon group), -COX (where X represents a halogen atom), -NH₂, and -NCO;
the cross-linking agent comprises at least one cross-linking agent selected from the group consisting of a polyol, a polyamine, a polycarboxylic acid, a polycarboxylate, a polycarboxylic acid halide, a polycarbodiimide, a polyisocyanate, and hydroquinone; and
the functional groups and the cross-linking agent are respectively selected in such a manner that combination of the functional groups and the cross-linking agent may prompt a cross-linking reaction with each other.

15. An electronic device according to claim 9, **characterized in that** the cross-linked sites are constituted by chemical bonding of the functional groups.

16. An electronic device according to claim 15, **characterized in that** reactions for causing the chemical bonding comprise at least one selected from the group consisting of dehydration condensation, a substitution reaction, an addition reaction, and an oxidation reaction.

17. An electronic device according to any one of claims 1 to 16, **characterized in that** the transporting layer is obtained by patterning the carbon nanotube structure into a shape corresponding to a formation area of the transporting layer.

18. An electronic device according to any one of claims 1 to 17, **characterized by** comprising a flexible substrate on which the electrode and the transporting layer are formed.

19. An integrated circuit, **characterized by** comprising: a substrate; and a plurality of electronic devices each of which is described in any one of claims 1 to 17, the electrodes being integrated on the substrate.

20. A method of manufacturing an electronic device that includes, on a base body, three or more electrodes and a transporting layer in which a carrier is transported in accordance with a voltage applied to the electrodes, **characterized by** comprising:
a supplying step of supplying the base body with a solution containing a plurality of carbon nanotubes to which functional groups are bonded; and
a cross-linking step of chemically bonding the functional groups, constructing a network structure in which the carbon nanotubes mutually cross-link, and forming a carbon nanotube structure used as the transporting layer.

21. A method of manufacturing an electronic device according to claim 20, **characterized in that** the supplying step comprises an applying step of applying the solution onto the base body, and the carbon nanotube structure is of a film shape.

22. A method of manufacturing an electronic device according to claim 20 or 21, **characterized in that** the carbon nanotubes comprise mainly single-wall carbon nanotubes.

23. A method of manufacturing an electronic device according to claim 20 or 21, **characterized in that** the carbon nanotubes comprise mainly multi-wall carbon nanotubes.

24. A method of manufacturing an electronic device according to any one of claims 20 to 23, **characterized in that** the solution contains a cross-linking agent for cross-linking the functional groups.

25. A method of manufacturing an electronic device according to claim 24, **characterized in that** the cross-linking agent comprises a non-self-polymerizable cross-linking agent.

26. A method of manufacturing an electronic device according to claim 24 or 25, **characterized in that** the functional groups comprise at least one group selected from the group consisting of -OH, -COOH, -COOR (where R represents a substituted or unsubstituted hydrocarbon group), -COX (where X represents a halogen atom), -NH₂, and -NCO, and the cross-linking agent comprises a cross-linking agent which may prompt a cross-linking reaction with the selected functional groups.

27. A method of manufacturing an electronic device according to claim 24 or 25, **characterized in that** the cross-linking agent comprises at least one cross-linking agent selected from the group consisting of a polyol, a polyamine, a polycarboxylic acid, a polycarboxylate, a polycarboxylic acid halide, a polycarbodiimide, a polyisocyanate, and hydroquinone, and the functional groups comprise functional groups which may prompt a cross-linking reaction with the selected cross-linking agent.

28. A method of manufacturing an electronic device according to claim 24 or 25, **characterized in that**:
the functional groups comprise at least one group selected from the group consisting of -OH, -COOH, -COOR (where R represents a substituted or unsubstituted hydrocarbon group), -COX (where X represents a halogen atom), -NH₂, and -NCO;
the cross-linking agent comprises at least one cross-linking agent selected from the group consisting of a polyol, a polyamine, a polycarboxylic acid, a polycarboxylate, a polycarboxylic acid halide, a polycarbodiimide, a polyisocyanate, and hydroquinone; and
the functional groups and the cross-linking agent are respectively selected in such a manner that combination of the functional groups and the cross-linking agent may prompt a cross-linking reaction with each other.

29. A method of manufacturing an electronic device according to claim 24 or 25, **characterized in that** the functional groups are comprise -COOR (where R represents a substituted or unsubstituted hydrocarbon group).

30. A method of manufacturing an electronic device according to claim 29, **characterized in that** the cross-linking agent comprises a polyol.

31. A method of manufacturing an electronic device according to claim 30, **characterized in that** the cross-linking agent comprises glycerin and/or ethylene glycol.

32. A method of manufacturing an electronic device according to claim 20, **characterized in that** a reaction for causing the chemical bonding comprises a reaction for chemically bonding the functional groups.

33. A method of manufacturing an electronic device according to claim 32, **characterized in that** the solution contains an additive for causing the chemical bonding of the functional groups.

34. A method of manufacturing an electronic device according to claim 33, **characterized in that** the reaction comprises dehydration condensation and the additive comprises a condensation agent.

35. A method of manufacturing a carbon nanotube structure according to claim 34, **characterized in that** the functional groups comprise at least one selected from -COOR (where R represents a substituted or unsubstituted hydrocarbon group), -COOH, -COX (where X represents a halogen atom), -OH, -CHO, and -NH₂.

36. A method of manufacturing an electronic device according to claim 35, **characterized in that** the functional groups comprise -COOH.

37. A method of manufacturing an electronic device according to claim 34, **characterized in that** the condensation agent comprises at least one compound selected from the group consisting of sulfuric acid, N-ethyl-N'-(3-dimethylaminopropyl)carbodiimide, and dicyclohexyl carbodiimide.

38. A method of manufacturing an electronic device according to claim 33, **characterized in that** the reaction comprises a substitution reaction and the additive comprises a base.

39. A method of manufacturing an electronic device according to claim 38, **characterized in that** the functional groups comprise at least one group selected from the group consisting of -NH₂, -X (where X represents a halogen atom), -SH, -OH, -OSO₂CH₃, and -OSO₂(C₆H₄)CH₃.

40. A method of manufacturing an electronic device according to claim 38, **characterized in that** the base comprises at least one compound selected from the group consisting of sodium hydroxide, potassium hydroxide, pyridine, and sodium ethoxide.

41. A method of manufacturing an electronic device according to claim 32, **characterized in that** the reaction comprises an addition reaction.

42. A method of manufacturing an electronic device according to claim 41, **characterized in that** the functional groups comprise -OH and/or -NCO.

43. A method of manufacturing an electronic device according to claim 32, **characterized in that** the reaction comprises an oxidation reaction.

44. A method of manufacturing an electronic device according to claim 43, **characterized in that** the functional groups comprise -SH.

45. A method of manufacturing an electronic device according to claim 43, **characterized in that** the solution contains an oxidation reaction accelerator.

46. A method of manufacturing an electronic device according to claim 45, **characterized in that** the oxidation reaction accelerator comprises iodine.

47. A method of manufacturing an electronic device according to claim 20, **characterized in that** the solution further contains a solvent.

48. A method of manufacturing an electronic device according to claim 24, **characterized in that** the cross-linking agent serves also as a solvent.

49. A method of manufacturing an electronic device according to any one of claims 20 to 48, **characterized by** comprising a patterning step of patterning the carbon nanotube structure layer into a shape corresponding to the transporting layer.

50. A method of manufacturing an electronic device according to claim 49, **characterized in that** the patterning step comprises a step involving: subjecting a carbon nanotube structure layer in a region having a pattern other than a pattern corresponding to the transporting layer on a surface of the base body to dry etching to remove the carbon nanotube structure layer in the region; and patterning the carbon nanotube structure layer into the pattern corresponding to the transporting layer.

51. A method of manufacturing an electronic device according to claim 49, **characterized in that** the patterning step comprises:
a resist layer forming step of forming a resist layer on the carbon nanotube structure layer in the region having the pattern corresponding to the transporting layer on the surface of the base body; and
a removing step of removing a carbon nanotube structure layer exposed in a region other than the region by subjecting a surface of the base body on which the carbon nanotube structure layer and the resist layer are laminated to dry etching.

52. A method of manufacturing an electronic device according to claim 51, **characterized in that**, in the removing step, the surface of the base body on which the carbon nanotube structure layer and the resist layer are laminated is irradiated with a radical of an oxygen molecule.

53. A method of manufacturing an electronic device according to claim 52, **characterized in that** an oxygen radical is generated by irradiating an oxygen molecule with ultraviolet light, the oxygen radical being used as the radical with which the surface of the base body on which the carbon nanotube structure layer and the resist layer are laminated is irradiated.

54. A method of manufacturing an electronic device according to claim 51, **characterized in that** the patterning step further includes, subsequent to the removing step, a resist layer peeling-off step of peeling off the resist layer formed in the resist layer forming step.

55. A method of manufacturing an electronic device according to claim 54, **characterized in that** the resist layer comprises a resin layer.

56. A method of manufacturing an electronic device according to claim 50, **characterized in that** the patterning step comprises a step involving: selectively irradiating the carbon nanotube structure layer in the region having a pattern other than the pattern corresponding to the transporting layer on the surface of the base body with an ion of a gas molecule in a form of an ion beam to remove the carbon nanotube structure layer in the region; and patterning the carbon nanotube structure layer into the pattern corresponding to the transporting layer.
